(19) Europäisches Patentamt
European Patent Office
Office européen des brevets

(11) Veröffentlichungsnummer: **0 256 981 B1**

(12) **EUROPÄISCHE PATENTSCHRIFT**

(45) Veröffentlichungstag der Patentschrift: **17.02.93**

(51) Int. Cl.$^5$: **C07F 17/00**, C08F 2/50, G03F 7/027

(21) Anmeldenummer: **87810431.4**

(22) Anmeldetag: **27.07.87**

Die Akte enthält technische Angaben, die nach dem Eingang der Anmeldung eingereicht wurden und die nicht in dieser Patentschrift enthalten sind.

# (54) Titanocene und deren Verwendung.

(30) Priorität: **01.08.86 CH 3100/86**

(43) Veröffentlichungstag der Anmeldung:
**24.02.88 Patentblatt 88/08**

(45) Bekanntmachung des Hinweises auf die Patenterteilung:
**17.02.93 Patentblatt 93/07**

(84) Benannte Vertragsstaaten:
**BE CH DE FR GB IT LI NL SE**

(56) Entgegenhaltungen:
**EP-A- 0 119 162**
**EP-A- 0 122 223**
**EP-A- 0 186 626**
**EP-A- 0 207 893**

(73) Patentinhaber: **CIBA-GEIGY AG**
**Klybeckstrasse 141**
**CH-4002 Basel(CH)**

(72) Erfinder: **Klingert, Bernd, Dr.**
**Möndenweg 87**
**W-7854 Inzlingen(DE)**
Erfinder: **Sitek, Franciszek, Dr.**
**Grossmattweg 11**
**CH-4106 Therwil(CH)**
Erfinder: **Rembold, Manfred, Dr.**
**Im Aeschfeld 21**
**CH-4147 Aesch(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 256 981 B1

## Beschreibung

Die vorliegende Erfindung betrifft Titanocene mit mindestens einem ein Fluoratom oder mindestens einem eine Fluoralkylgruppe enthaltenden aromatischen Rest, eine photopolymerisierbare Zusammensetzung aus ethylenisch ungesättigten Verbindungen, die diese Titanocene als Photoinitiatoren enthält, ein mit dieser Zusammensetzung beschichtetes Substrat und ein Verfahren zur Herstellung photographischer Reliefabbildungen unter Verwendung dieses beschichteten Substrates.

Aus der EP-A-0 122 223 und der EP-A-0 186 626 ist es bekannt, dass Titanocene mit Fluor- oder Fluoralkylphenylliganden ausgezeichnete Photoinitiatoren sind. Es hat sich gezeigt, dass eine Substitution im Cyclopentadienylrest die Lichtempfindlichkeit dieser Titanocene vermindert. Die Lichtempfindlichkeit wird ferner durch die geringe Löslichkeit dieser kristallinen Verbindungen in den Komponenten der lichtempfindlichen Zusammensetzungen beeinflusst.

Ein Gegenstand vorliegender Erfindung sind Titanocene der Formel I

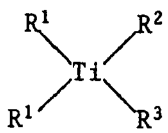

(I),

worin beide $R^1$ unabhängig voneinander gegebenenfalls durch $C_1$-$C_{18}$-Alkyl, $C_2$-$C_{18}$-Alkenyl, Chlor, Phenyl oder Cyclohexyl substituiertes Cyclopentadienyl$^{\ominus}$ oder beide $R^1$ zusammen einen substituierten Rest der Formel II bedeuten,

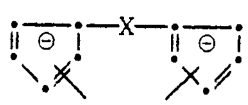

(II)

worin X $(CH_2)_n$ mit n = 1, 2 oder 3, gegebenenfalls durch Phenyl substituiertes Alkyliden mit 2 bis 12 C-Atomen oder Cycloalkyliden mit 5 bis 7 Ringkohlenstoffatomen bedeutet,
$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch F, $CF_3$, $C_2F_5$, $CF_2Cl$ oder $CF_2CH_3$ substituiert ist, und ausserdem durch eine oder mehrere der Gruppen Halogen, $C_1$-$C_{12}$-Alkyl, $C_1$-$C_4$-Alkoxy, $C_2$-$C_{10}$-Alkoxycarbonyl, Aminocarbonyl mit bis zu 12 C-Atomen oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, oder, wenn $R^2$ einen durch F substituierten aromatischen Ring bedeutet, dieser durch mindestens einen gegebenenfalls veretherten oder veresterten Polyoxaalkylenrest substituiert sein kann, wobei dieser Rest entweder direkt oder über eine Brückengruppe an den aromatischen Ring gebunden sein kann, oder $R^2$ und $R^3$ zusammen einen Rest der Formel III bedeuten,

—Q—Y—Q— (III)

in dem Q einen carbocyclischen aromatischen Ring bedeutet, der in 2-Stellung zur Y-Gruppe an das Titanatom gebunden ist und in 3-Stellung durch Fluor substituiert ist, Y Methylen, gegebenenfalls durch Phenyl substituiertes $C_2$-$C_{12}$-Alkyliden, $C_5$-$C_7$-Cycloalkyliden, eine Gruppe -$NR^5$-, -O-, -S-, -SO-, -$SO_2$-, -CO-, -$SiR^4_2$ - oder -$SnR^4_2$ - bedeutet und $R^5$ Wasserstoff, $C_1$-$C_{12}$-Alkyl, Cyclohexyl, Phenyl, Tolyl oder Benzyl bedeutet, und die Reste $R^4$ unabhängig voneinander $C_1$-$C_{12}$-Alkyl, Cyclohexyl, Phenyl oder Benzyl sind, $R^3$ eine der für $R^2$ angegebenen Bedeutungen hat oder $C_2$-$C_{12}$-Alkinyl, unsubstituiertes oder im Phenylrest durch Halogen oder $C_1$-$C_4$-Alkyl substituiertes Phenylalkinyl mit 2-5 C-Atomen im Alkinrest oder eine Gruppe -$SiR^4_3$ , -$SnR^4_3$ , worin die $R^4$ die zuvor angegebene Bedeutung haben, -$N_3$ oder -CN bedeutet, oder $R^3$ zusätzlich Halogen, -NCO oder NCS ist, wenn $R^2$ einen durch -$CF_3$, -$C_2F_5$, $CF_2Cl$ oder $CF_3CH_3$ substituierten aromatischen Ring darstellt,
wobei die Titanocene dadurch gekennzeichnet sind, dass mindestens ein $R^1$ durch mindestens eine Gruppe der Formeln IV oder V

$(R^6)_3Z-$ (IV)

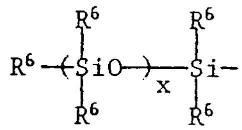 (V)

substituiert ist, worin Z für Si oder Ge steht, x 1, 2 oder 3 bedeutet, und jedes $R^6$ unabhängig lineares oder verzweigtes $C_1$-$C_{18}$-Alkyl, $C_1$-$C_4$-Halogenalkyl; Phenyl, $C_1$-$C_{18}$-Alkoxy oder $C_1$-$C_{18}$-Alkoxymethyl darstellt.

Eine bevorzugte Ausführungsform ist dadurch gekennzeichnet, dass in Formel I ein $R^1$ ein unsubstituiertes Cyclopentadienyl ist und das andere $R^1$ bis Zu 3 Substituenten enthält, oder jedes $R^1$ ein substituiertes Cyclopentadienyl ist, wobei mindestens ein Substituent der Formel IV oder V entspricht.

Bevorzugte Reste $R^1$ sind solche Reste, worin $R^1$ nur Substituenten der Formeln IV oder V enthält.

In Formel V steht x bevorzugt für 1 und Z in Formel IV bevorzugt für Si.

$R^6$ ist bevorzugt $C_1$-$C_{18}$-Alkyl oder $C_1$-$C_4$-Halogenalkyl, $C_1$-$C_4$-Alkoxy oder Phenyl. Beispiele für $R^6$ sind Methyl, Ethyl, n- und i-Propyl, n-, i- oder t-Butyl, Pentyl, Hexyl, 1,1,2,2-Tetramethylethyl, Heptyl, Octyl, 2-Ethyloctyl, Nonyl, Decyl, Undecyl, Dodecyl, Tetradecyl, Hexadecyl, Octadecyl, Chlormethyl, Brommethyl, 2-Chlorethyl, Methoxy, Ethoxy, Isopropoxy, Butoxy oder Phenyl.

Eine bevorzugte Untergruppe sind solche Titanocene, in denen in Formel IV ein $R^6$ $C_1$-$C_{18}$-Alkyl, $C_1$-$C_4$-Halogenalkyl, $C_1$-$C_4$-Alkoxy oder Phenyl und die anderen beiden $R^6$ Methyl sind. Besonders bevorzugt ist die Gruppe der Formel IV eine Trimethylsilylgruppe. Weitere Beispiele für Reste der Formeln IV sind Triethylsilyl, Ethyldimethylsilyl, n- oder i-Propyldimethylsilyl, Tri-n-propylsilyl, n-, i- oder t-Butyldimethylsilyl, Tri-n-butylsilyl, Tri-n-pentylsilyl, n-Pentyl-dimethylsilyl, n-Hexyldimethylsilyl, (1,1,2,2-Tetramethylethyl)-dimethylsilyl, n-Octyl-dimethylsilyl, n-Decyldimethylsilyl, n-Dodecyldimethylsilyl, n-Octadecyldimethylsilyl, sowie entsprechende Germylreste. Beispiele für Reste der Formel V sind Trimethylsiloxy-dimethylsilyl, Phenyldimethylsiloxy-dimethylsilyl oder Butyldimethylsiloxy-dimethylsilyl.

Eine andere bevorzugte Untergruppe sind solche Titanocene, bei denen ein $R^1$ ein durch die Gruppen der Formeln IV oder V substituiertes Cyclopentadienylanion ist und das andere $R^1$ die gleiche Bedeutung hat, oder ein Cyclopentadienyl- oder Methylcyclopentadienylanion ist.

Die beiden $R^1$ in Formel I stellen bevorzugt gleiche Reste dar.

Die aromatischen Reste $R^2$ und $R^3$ sind bevorzugt je durch 2 Fluoratome in den Orthostellungen substituiert; oder bevorzugt durch eine $CF_3$-, $C_2F_5$-, $CF_2Cl$- oder $CF_2CH_3$-Gruppe, besonders wenn $R^3$ nicht die gleiche Bedeutung wie $R^2$ hat. Die Substitution mit F und $CF_3$ ist bevorzugt.

$R^2$ als heterocyclischer aromatischer und 5-gliedriger Rest enthält bevorzugt ein Heteroatom und als 6-gliedriger Ring bevorzugt 1 oder 2 Heteroatome. Beispiele für solche mit 2 Fluoratomen substituierte Ringe sind: 2,4-Difluorpyrr-3-yl, 2,4-Difluorfur-3-yl, 2,4-Difluorthiophen-3-yl, 2,4-Difluorpyrid-3-yl, 3,5-Difluorpyrid-4-yl, 4,6-Difluorpyrimid-5-yl.

Beispiele für fluoralkyl-substituierte carbocyclisch-aromatische Ringe $R^2$ sind: 4-(Trifluormethyl)inden-5-yl, 5,7-Di(trifluormethyl)indan-6-yl, 2-(Trifluormethyl)fluoren-3-yl, 3-(Trifluormethyl)naphth-2-yl und besonders 2-(Trifluormethyl)phen-1-yl.

Beispiele für solche fluoralkyl-substituierte heterocyclisch-aromatische Ringe sind: 2-(Trifluormethyl)-pyrr-3-yl, 2-(Trifluormethyl)fur-3-yl, 2-(Trifluormethyl)thiophen-3-yl, 2-(Trifluormethyl)pyrid-3-yl, 3-(Trifluormethyl)pyrid-4-yl, 4-(Trifluormethyl)pyrimid-5-yl.

$R^2$ und $R^3$ zusammen als Rest der Formel III können z.B. sein:

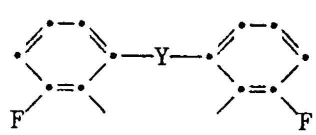

Y in Formel III und obiger Formel ist bevorzugt Methylen, Ethyliden, Propyliden, -S- oder -O-.

$R^2$ kann andere Substituenten tragen, wie Halogenatome, Alkyl- oder Alkoxygruppen, Alkoxycarbonyl- oder Aminocarbonylgruppen, Aminogruppen oder Aminoalkylgruppen sowie deren Quaternierungsprodukte. Beispiele für solche Substituenten sind Fluor, Chlor, Brom, Methyl, Ethyl, iso-Propyl, tert.Butyl, n-Nonyl oder n-Dodecyl, Methoxy, Ethoxy oder Butoxy, Methoxycarbonyl, Ethoxycarbonyl, Butoxycarbonyl, 2-Ethylhexyloxy oder n-Decyloxy, Aminocarbonyl, Butylaminocarbonyl, Diethylaminocarbonyl oder Pyrrolidi-

nocarbonyl, $-NH_2$, $-NHC_4H_9$, $-N(CH_3)_2$, $-N(CH_3)_3^{\oplus}Cl^{\ominus}$, Morpholino, Piperidino, $-CH_2NH_2$, $-CH_2N(C_2H_5)_2$, $-CH_2N(C_2H_5)_3^{\oplus}Br^{\ominus}$ oder Pyrrolidinomethyl.

$R^4$ enthält als Alkyl bevorzugt 1 bis 6, besonders 1 bis 4 C-Atome und ist besonders Methyl.

Eine bevorzugt Ausführungsform ist dadurch gekennzeichnet, das $R^2$ und $R^3$ in Formel I gleich sind und einen 6-gliedrigen carbocyclischen oder 5- oder 6-gliedrigen heterocyclischen aromatischen Ring bedeuten, der in einer oder beiden Orthostellungen zur Metallkohlenstoffbindung durch F oder in einer Orthostellung durch $CF_3$, $C_2F_5$,$CF_2Cl$ oder $CF_2CH_3$ substituiert ist und weitere wie zuvor definierte Substituenten enthalten kann. Insbesondere bedeuten $R^2$ und $R^3$ 2,6-Difluorphen-1-yl, das 1 bis 3 wie zuvor definierte Substituenten enthalten kann.

Eine bevorzugte Untergruppe ist dadurch gekennzeichnet, dass $R^2$ und $R^3$ einen Rest der Formel

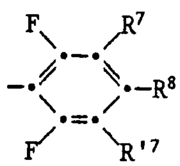

bedeuten, worin $R^7$, $R'^7$ und $R^8$ unabhänngig voneinander H, F, Cl oder Br bedeuten, oder $R^7$ und $R'^7$ unabhängig voneinander je H, F, Cl oder Br bedeuten, und $R^8$ eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen ist, oder $R^8$ ein gegebenenfalls veresterter oder veretherter Polyoxaalkylenrest ist, der direkt oder über eine Brückengruppe an den Phenylring gebunden ist.

$R^2$ enthält bevorzugt mindestens einen gegebenenfalls veretherten oder veresterten Polyoaxaalkylenrest, der direkt oder über eine Brückengruppe an den Arylrest gebunden ist. Der Polyoxaalkylenrest ist bevorzugt mit $C_1$-$C_{18}$-, besonders $C_1$-$C_{12}$- und insbesondere $C_1$-$C_6$-Alkyl verethert oder $C_1$-$C_{18}$-, besonders $C_1$-$C_{12}$- und insbesondere $C_1$-$C_6$-Acyl verestert. Beispiele für Alkyl sind Methyl, Ethyl, n- und i-Propyl, n-, i- und t-Butyl, Pentyl, Hexyl, Heptyl, Octyl, Nonyl, Docyl, Undecyl, Dodecyl, Tetradecyl, Hexadecyl, Octadecyl. Beispiele für Acyl sind Formyl, Acetyl, Propionyl, Trifluroacetyl, Butyryl, Pentanoyl, Hexanoyl, Octanoyl, Dodecanoyl, Benzoyl. Bevorzugt sind veretherte Polyoxaalkylenreste.

Der Polyoxaalkylenrest enthält bevorzugt 1 bis 20, besonders 1 bis 12 und insbesondere 1 bis 6 Oxaalkyleneinheiten. Das Alkylen im Polyoxaalkylenrest enthält bevorzugt 2 bis 6, besonders 2 bis 4 C-Atome und stellt insbesondere Ethylen oder 1,2-Propylen dar. Weitere Beispiele sind 1,3-Propylen, 1,2-, 1,3- und 1,4-Butylen, Pentylen und Hexylen. Im Polyoxaalkylenrest können auch verschiedene Alkylenreste enthalten sein.

In einer bevorzugten Ausführungsform entspricht der Polyoxaalkylenrest der Formel

$$\left( C_zH_{2z}O \right)_o R^9 ,$$

worin z eine Zahl von 2-6, o eine Zahl von 1 bis 20 und $R^9$ H oder $C_1$-$C_{18}$-Alkyl darstellen.

Wenn der Polyoxyalkylenrest über eine Brückengruppe an den aromatischen Ring gebunden ist, so kann es sich bei den Brückengruppen beispielsweise um eine der folgenden Gruppen handeln:

$-S-$, $-O-$, $-OSO_2-$, $-CH_2O-$, $-CH(CH_3)O-$, $-SO_2-$, $-C(O)O-$, $-CH\!<^{O-}_{O-}$, $-N\!<$, $-NR^{10}-$, $-\overset{|}{N}CH_2CH_2N\!<$, $-NR^{10}CH_2CH_2N\!<$, $-\overset{|}{N}CH_2CH_2-NR^{10}-$, $-NR^{10}CH_2CH_2NR^{10}-$, $-NCH_2CH_2NR^{10}_2$, $-CH_2N\!<$, $-CH_2NR^{10}-$, $-CH(COO-)_2$, $-CH_2COO-$, $-CONR^{10}-$, $-CH(CONR^{10}-)_2$, $-CH_2(CON\!<)_2$, $-CH_2CONR^{10}-$, $-CH_2CON\!<$, $-CON\!<$, $-OC(O)O-$, $-N(R^{10})-COO-$, $-CH_2N(R^{10})-COO-$, $-N(R^{10})-CONH-$, $-CH_2N(R^{10})-CONH-$, $-C_nH_{2n}OC(O)C_mH_{2m}O-$ mit n = 0, 1 oder 2 und m = 1-6, $-C_nH_{2n}OSiR^{11}_{3-y}O_y-$ mit n = 0, 1 oder 2 und y = 1-3, $-OCH_2CH_2OSiR^{11}_{3-y}O_y-$, $-COOSiR^{11}_{3-y}O_y-$ oder $-CH_2COOSiR^{11}_{3-y}O_y-$ mit y = 1-3, worin $R^{10}$ H, $C_1$-$C_{18}$-Alkyl oder $C_1$-$C_{18}$-Acyl und $R^{11}$ $C_1$-$C_{12}$-Alkyl oder Phenyl sind.

In einer bevorzugten Ausführungsform stellen $R^9$ $C_1$-$C_{12}$-Alkyl, $R^{10}$ H oder $C_1$-$C_{12}$-Alkyl und $R^{11}$ $C_1$-$C_6$-Alkyl, z eine Zahl von 2 bis 4 und o eine Zahl von 2 bis 6 dar.

In einer besonders bevorzugten Gruppe der erfindungsgemässen Titanocene entspricht der über eine Brückengruppe gebundene Polyoxaalkylenrest den Formeln

$$-O-(CH_2CH_2O)_o-R^9$$

$$-NR^{10}-\overset{O}{\overset{\|}{C}}-O-(CH_2CH_2O)_o-R^9$$

$$-N[(CH_2CH_2-O)_o-R^9]_2$$

$$-NR^{10}(CH_2CH_2O)_o-R^9$$

$$-\overset{O}{\overset{\|}{C}}O-(CH_2CH_2O)_o-R^9$$

$$-\overset{O}{\overset{\|}{C}}NR^{10}(CH_2CH_2O)_o-R^9 \quad \text{oder}$$

$$-O\overset{O}{\overset{\|}{C}}O(CH_2CH_2O)_o-R^9 \quad ,$$

worin $R^9$ $C_1$-$C_{12}$-Alkyl bedeutet, $R^{10}$ H oder $C_1$-$C_6$-Alkyl darstellt und o für eine Zahl von 2 bis 6 steht.

$R^3$ enthält als Alkinyl bevorzugt 2 bis 6 C-Atome. Beispiele sind Ethinyl, Propinyl, Butinyl, Pentinyl und Hexinyl. $R^3$ als Phenylalkinyl ist bevorzugt substituiertes oder unsubstituiertes Phenylethinyl. Beispiele sind (Methylphenyl)-, (Fluorphenyl)- und (Chlorphenyl)alkinyl. $R^4$ in den $(R^4)_3Si$- und $(R^4)_3Ge$-Gruppen enthält bevorzugt 1 bis 4 C-Atome und ist besonders Methyl. Beispiele für solche Gruppen sind zuvor erwähnt worden. Bevorzugt ist Trimethylsilyl und Trimethylgermyl.

Eine bevorzugte Gruppe von Titanocenen der Formel I sind solche, worin $R^2$ einen Rest der Formel

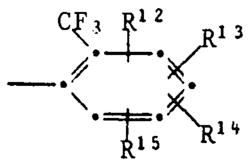

bedeutet, worin $R^{12}$, $R^{13}$, $R^{14}$ und $R^{15}$ unabhängig voneinander Wasserstoff, $-CF_3$, Brom, Chlor oder Fluor bedeuten, und $R^3$ die Bedeutung von $R^2$ hat oder für Halogen oder $-N_3$, -CN, -NCO oder -NCS steht. Bevorzugt sind darunter solche Titanocene, worin $R^{12}$, $R^{13}$ und $R^{14}$ Wasserstoff sind, $R^{15}$ in Orthostellung zur Metall-Bindung steht und Fluor oder Wasserstoff bedeutet. $R^3$ steht bei solchen fluoralkylierten Titanocenen besonders für F, Cl, Br, $N_3$, CN, NCO oder NCS.

Beispiele für Verbindungen der Formel I sind:
Bis(R-cyclopentadienyl)-bis(pentafluorphenyl)-titan
Bis(R-cyclopentadienyl)-bis(3-brom-tetrafluorphenyl)-titan
Bis(R-cyclopentadienyl)-bis(4-brom-tetrafluorphenyl)-titan
Bis(R-cyclopentadienyl)-bis(3,5-dichlor-2,4,6-trifluorphenyl)-titan
Bis(R-cyclopentadienyl)-bis(4-morpholino-tetrafluorphenyl)-titan
Bis(R-cyclopentadienyl)-bis(4-[4′methylpiperazino]-tetrafluorphenyl)-titan
Bis(R-cyclopentadienyl)-bis(2,4,6-trifluorphenyl)-titan
Bis(R-cyclopentadienyl)-bis(2,3,5,6-tetrafluorphenyl)-titan
Bis(R-cyclopentadienyl)-bis(2,3,6-trifluorphenyl)-titan
Bis(R-cyclopentadienyl)-bis(2,6-difluorphenyl)-titan
Bis(R-cyclopentadienyl)-bis(2,4,5-trifluorphenyl)-titan
Bis(R-cyclopentadienyl)-bis(2,3-difluorphenyl)-titan
Bis(R-cyclopentadienyl)-bis(2,5-difluorphenyl)-titan
Bis(R-cyclopentadienyl)-bis[2,3,5,6-tetrafluor-4-(1′,4′-dioxaoctylphenyl]-titan
Bis(R-cyclopentadienyl)-bis[2,3,5,6-tetrafluor-4-(1′,4′,7′-trioxaoctylphenyl]-titan
Bis(R-cyclopentadienyl)-bis(2,6-difluor-3-[1′,4′,7′,10′-tetraoxadodecyl]-phenyl)-titan
Bis(R-cyclopentadienyl)-bis(2,6-difluor-3-[1′,4′,7′-trioxahendecyl)-phenyl]-titan
Bis(R-cyclopentadienyl)-3,4,5,6,3′,4′,5′,6′-octafluordiphenylsulfid-2,2′-diyl-titan
Bis(R-cyclopentadienyl)-(2-trifluormethyl-phenyl)-titan-chlorid oder -bromid oder -fluorid
Bis(R-cyclopentadienyl)-bis(2-trifluormethyl-phenyl)-titan
Bis(R-cyclopentadienyl)-(2-trifluormethyl-6-fluorphenyl)-titan-fluorid
Bis(R-cyclopentadienyl)-2,5-bis(trifluormethyl)phenyl-titan-chlorid
Bis(R-cyclopentadienyl)-2-(trifluormethyl)phenyl-titan-rhodanid oder -isocyanat oder -cyanid
Bis(R-cyclopentadienyl)-(2-trifluormethyl-4-methoxyphenyl)-titan-chlorid
Bis(R-cyclopentadienyl)-bis(2-trifluormethyl-4-tolyl)-titan.

Darin bedeutet R Trimethylsilyl, Trimethylgermyl, Ethyldimethylsilyl, n-oder t-Butyldimethylsilyl, (1,1,2,2-Tetramethylethyl)dimethylsilyl Hexyldimethylsilyl, Octyldimethylsilyl oder Octadecyldimethylsilyl.

Die Herstellung der Titanocene der Formel I kann nach bekannten oder analogen Verfahren erfolgen, z.B. indem man 1 Mol einer Verbindung der Formel VI

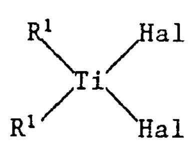

(VI)

worin $R^1$ die in Anspruch 1 angegebene Bedeutung hat und Hal für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ und $R^3$ die vorhin angegebene Bedeutung haben.

Die Verbindungen der Fomel VI sind teilweise bekannt oder können nach analogen Verfahren erhalten werden, indem man Natriumcyclopentadienyl mit Verbindungen der Formel $(R^6)_3ZCl$ oder $R^6(SiOR^6_2)_xSiR^6_2Cl$ umsetzt, die erhaltenen substituierten Cyclopentadiene erneut mit Natrium reagieren lässt und dann 2

Mol davon mit 1 Mol $Ti(Hal)_4$ umsetzt. Sind die beiden Reste $R^1$ verschieden, so geschieht ihre Verknüpfung mit dem Titan analog in 2 Stufen.

$R^2$- bzw. $R^3$-Halogenide, z.B. Fluoride, Chloride und Bromide, und die Herstellung der entsprechenden Lithiumverbindungen sind in der EP-A-0 122 223 und der EP-A-0 186 626 beschrieben. Auch das Prinzip der Herstellung der Titanocene ist dort beschrieben.

Bei den erfindungsgemässen Verbindungen der Formel I handelt es sich meist um kristalline, orange gefärbte Verbindungen. Verbindungen, in deren $R^2$ einen Polyoxaalkylenrest enthält, können auch flüssig sein. Die Verbindungen der Formel I weisen eine höhere Löslichkeit als Verbindungen ohne Silyl- bzw. Germylgruppe auf, wobei die Grösse der Silyl- bzw. Germylsubstituenten die thermischen und photochemischen Eigenschaften nicht beeinträchtigt. Zudem kann durch geeignete Wahl der $R^6$-Reste die Löslichkeit gezielt beeinflusst werden.

Die Verbindungen sind dunkellagerstabil und können ohne Schutzgas gehandhabt werden. Sie eignen sich alleine hervorragend als sehr wirksame Photoinitiatoren für die lichtinduzierte Polymerisation ethylenisch ungesättigter Verbindungen. Sie zeichnen sich hierbei durch eine sehr hohe Lichtempfindlichkeit und Wirksamkeit über einen grossen Wellenlängenbereich von ca. 200 nm (UV-Licht) bis etwa 600 nm aus. Ferner vermögen die Titanocene auch wirksam die Polymerisation unter dem Einfluss von Wärme zu initiieren, wobei ein Erwärmen auf 170 °C bis 240 °C zweckmässig ist. Selbstverständlich kann auch Lichteinwirkung und Erwärmung zur Polymerisation benutzt werden, wobei eine Erwärmung nach der Belichtung tiefere Temperaturen, z.B. 80-150 °C, zur Polymerisation erlaubt.

Ein weiterer Gegenstand vorliegender Erfindung ist eine durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I als Photoinitiator.

Die Zusammensetzungen können weiter Photoinitiatoren (c), z.B. solche aus der Klasse der Benzilketale, 4-Aroyl-1,3-dioxolane, Dialkoxyacetophenone, $\alpha$-Hydroxyacetophenone, $\alpha$-Aminoacetophenone oder Mischungen davon enthalten. Das Gewichtsverhältnis dieser Komponenten (c):(b) kann z.B. von 1:1 bis 30:1, bevorzugt 5:1 bis 15:1 betragen. Der Vorteil besteht darin, dass man mit geringeren Mengen an Titanocenen der Formel I gleiche oder verbesserte Lichtempfindlichkeiten erzielen kann.

Die Zusatzmenge der erfindungsgemässen Titanocene oder ihrer Abmischungen mit anderen Photoinitiatoren richtet sich im wesentlichen nach wirtschaftlichen Gesichtspunkten, deren Löslichkeiten und nach gewünschten Empfindlichkeit. Im allgemeinen werden 0,01 bis 20, vorzugsweise 0,05-10 und besonders 0,1 bis 5 Gew.% verwendet, bezogen auf die Komponente (a).

Als Komponente (a) kommen solche ethylenisch ungesättigten monomeren, oligomeren und polymeren Verbindungen in Frage, die durch Photopolymerisation zu höhermolekularen Produkten reagieren und hierbei ihre Löslichkeit verändern.

Besonders geeignet sind Ester von ethylenisch ungesättigter Carbonsäuren und Polyolen oder Polyepoxiden, sowie Polymere mit ethylenisch ungesättigten Gruppen in der Kette oder in Seitengruppen, wie z.B. ungesättigte Polyester, Polyamide und Polyurethane und Copolymere hiervon, Polybutadien und Polybutadien-Copolymere, Polyisopren und Polyisopren-Copolymere, Polymere und Copolymere mit (Meth)Acrylgruppen in Seitenketten, sowie Mischungen von einem oder mehrerer solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, Bisphenole, wie Bisphenol-A, sowie Novolake und Resole. Beispiele für Polyepoxide sind solche auf der Basis der genannten Polyole, besonders der aromatische Polyole und Epichlorhydrin. Ferner sind auch Polymere oder Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Diole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3 oder 1,4-Butandiol, Pentandiol, Hexandiol, Octandiol, Dodecandiol, Diethylenglykol, Triethylenglykol, Polyethylenglykole mit Molekulargewichten von bevorzugt 100 bis 1500, 1,3-Cyclopentandiol, 1,2-, 1,3- oder 1,4-Cyclohexandiol, 1,4-Dihydroxymethylcyclohexan, Glycerin, Tris-($\beta$-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit

anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldimethacrylat, 1,3-Butandioldiacrylat, 1,3-Butandioldimethacrylat, 1,4-Butandioldiitaconat, Sorbittriacrylat, Sorbittetraacrylat, Sorbittetramethacrylat, Sorbitpentaacrylat, Sorbithexaacrylat, Pentaerythrit-modifiziert-triacrylat, ein Oligoesteracrylat, ein Oligoestermethacrylat, Glyzerindi- und -triacrylat, 1,4-Cyclohexandiacrylat, Bisacrylate und Bismethacrylate von Polyethylenglykol mit Molekulargewicht von 100-1500, oder Gemischen davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für Amine sind Alkylendiamine wie Ethylendiamin, 1,2- oder 1,3-Propylendiamin, 1,2-, 1,3-oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-$\beta$-aminoethylether, Diethylentriamin, Triethylentetramin, Di-($\beta$-aminoethoxy)- oder Di($\beta$-aminopropoxy)ethan. Weitere geeignete Polyamine sind Polymere und Copolymere mit Aminogruppen in der Seitenkette und Oligoamide mit Aminoendgruppen.

Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, $\beta$-Methacryl-amidoethylmethacrylat, N[($\beta$-hydroxyethyloxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamid können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)Acrylate, Acrylnitril, Styrol oder Vinylchlorid. Polymer mit (Meth)Acrylatgruppen in der Seitenkette sind ebenfalls bekannt. Es kann sich z.B. um Umsetzungsprodukte von Epoxidharzen auf Novolakbasis mit (Meth)Acrylsäure handeln, um Homo- oder Copolymere des Polyvinylalkohols oder deren Hydroxyalkylderivaten, die mit (Meth)Acrylsäure verestert sind, oder um Copolymere von Alkyl-(Meth)Acrylaten mit Hydroxyalkyl(meth)acrylaten.

Die photopolymerisierbaren Verbindungen können alleine oder in beliebigen Mischungen eingesetzt werden. Bevorzugt werden Gemische von Polyol-(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittel kann z.B. 5-95, vorzugsweise 10-90 und besonders 50-90 Gew.% betragen, bezogen auf die gesamte Zusammensetzung. Die Wahl des Bindemittels erfolgt je nach dem Anwendungsgebiet und den hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000 bis 1 000 000. Beispiele sind: Homo- und copolymere Acrylate und Methacrylate, z.B. Copolymere aus Methylmethacrylat/Ethylacrylat/Methacrylsäure, Poly(methacrylsäurealkylester), Poly(acrylsäurealkylester), wobei Alkyl = $C_1$-$C_{20}$-Alkyl ist, Celluloseester und -ether wie Cellulsoeacetat, Celluloseacetatbutyrat, Methylcellulose, Aethylcellulose, Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polyamide und Polycaprolactame wie Polycaprolactam und Poly(hexamethylenadipamid),Polyester wie Poly(ethylenglykolterephthalat) und Poly(hexamethylenglykolsuccinat).

Die erfindungsgemässen Zusammensetzungen eignen sich als Beschichtungsmittel für Substrate aller Art, z.B. Holz, Papier, Keramik, Kunststoffe wie Polyester und Celluloseacetatfilme, und Metalle, wie Kupfer

und Aluminium, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen auf den Substraten.

Die Herstellung der beschichteten Substrate kann erfolgen, indem man eine flüssige Zusammensetzung, eine Lösung oder Suspension auf das Substrat aufbringt. Flüssige Zusammensetzungen ohne Lösungsmittel sind bevorzugt. Hierbei kann es zweckmässig sein, die erfindungsgemässen Titanocene in Form eines flüssigen Photoinitiatorengemisches, enthaltend andere Photoinitiatoren, z.B. ein Benzilketal, ein 4-Aroyl-1,3-dioxolan, ein Dialkoxyacetophenon, ein $\alpha$-Hydroxy- oder $\alpha$-Amino-acetophenon oder Mischungen hiervon, und ein Titanocen der Formel I, einzusetzen. Besonders vorteilhaft sind flüssige Mischungen aus flüssigen bis festen Photoinitiatoren und flüssigen Titanocenen, oder flüssigen Photoinitiatoren und sirupösen bis festen Titanocenen. Diese Gemische bieten anwendungstechnische Vorteile und zeichnen sich durch eine hohe Dunkellagerstabilität aus.

Beispiele für Benzilketale sind solche der Formel

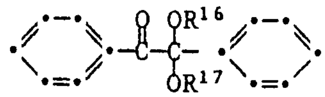

$R^{16} = R^{17} =$

$-CH_3$
$-CH_2CH_3$
$-(CH_2)_2CH_3$
$-(CH_2)_3CH_3$
$-CH_2CH_2CH(CH_3)_2$

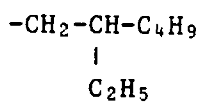

$-(CH_2)_9CH_3$
$-C_{10}H_{21}$-iso
$-C_{12}H_{25}$-n
$-C_9H_{19}$ bis $-C_{11}H_{23}$-Gemisch
$-C_{12}$-$H_{25}$-bis-$C_{15}H_{31}$-Gemisch
$-CH_2CH=CH_2$
$-CH(CH_3)CH=CH_2$
$-CH_2CH_2OC_3H_7$-iso
$-CH_2CH_2OC_4H_9$
$-CH_2CH_2OCH_2CH=CH_2$
$-CH(CH_3)$-$CH_2OC_4H_9$
$-CH_2COOCH_3$
$-CH_2COOC_4H_9$
$-CH(CH_3)COOCH_3$
$-CH_2CH_2COOC_2H_5$
$-CH(CH_3)CH_2COOCH_3$
$-CH_2CH_2CH(CH_3)OCH_3$

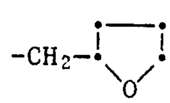

$-(CH_2CH_2O)_2CH_3$
$-(CH_2CH_2O)_2C_2H_5$
$-(CH_2CH_2O)_2C_4H_9$
$-(CH_2CH_2O)_3CH_3$
$-(CH_2CH_2O)_3C_2H_5$

$-(CH_2CH_2O)_3C_{12}H_{25}$
$-(CH_2CH_2O)_5C_{10}H_{21}$
$-(CH_2CH_2O)_8C_9H_{19}$-bis-$C_{11}H_{23}$ (Gemisch)

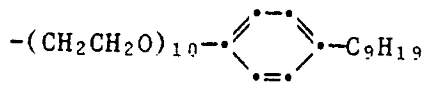

$-CH_2CH_2N(C_2H_5)_2$

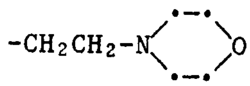

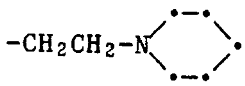

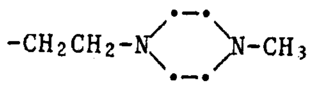

$R^{17} = CH_3$, $R^{16} = C_6H_{13}$
$R^{17} = CH_3$, $R^{16} = C_{10}H_{21}$
$R^{17} = CH_3$, $R^{16} = -(CH_2CH_2O)_3-C_{12}H_{25}$ bis-$C_{15}H_{31}$ (Gemisch)
$R^{17} = CH_3$, $R^{16} = -(CH_2CH_2O)_5-C_9H_{19}$ bis $-C_{11}H_{23}$ (Gemisch)
$R^{17} = CH_3$,

$R^{16}$ = 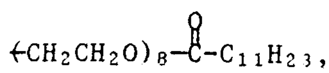

sind.

Beispiele für 4-Aroyl-1,3-dioxolane sind:
4-Benzoyl-2,2,4-trimethyl-1,3-dioxolan
4-Benzoyl-4-methyl-2,2-tetramethylen-1,3-dioxolan
4-Benzoyl-4-methyl-2,2-pentamethylen-1,3-dioxolan
cis-trans 4-Benzoyl-2,4-dimethyl-2-methoxymethyl-1,3-dioxolan
cis-trans 4-Benzoyl-4-methyl-2-phenyl-1,3-dioxolan
4-(4-Methoxybenzoyl)-2,2,4-trimethyl-1,3-dioxolan
4-(4-Methoxybenzoyl)-4-methyl-2,2-pentamethylen-1,3-dioxolan
4-(4-Methoxybenzoyl)-2,2,4-trimethyl-1,3-dioxolan
cis-trans 4-Benzoyl-2-methyl-4-phenyl-1,3-dioxolan
4-Benzoyl-2,2,4,5,5-pentamethylen-1,3-dioxolan
cis-trans 4-Benzoyl-2,2,4,5-tetramethyl-1,3-dioxolan
cis-trans 4-Benzoyl-4-methyl-2-pentyl-1,3-dioxolan
cis-trans 4-Benzoyl-2-benzyl-2,4-dimethyl-1,3-dioxolan
cis-trans 4-Benzoyl-2-(2-furyl)-4-methyl-1,3-dioxolan
cis-trans 4-Benzoyl-5-phenyl-2,2,4-trimethyl-1,3-dioxolan
4-(4-Methoxybenzoyl)-2,2,4,5,5-pentamethyl-1,3-dioxolan.

Biespiele für Dialkoxyacetophenone sind:
$\alpha,\alpha$-Dimethoxyacetophenon
$\alpha,\alpha$-Diethoxyacetophenon
$\alpha,\alpha$-Di-isopropoxyacetophenon
$\alpha,\alpha$-Di-(2-methoxyethoxy)acetophenon
$\alpha$-Butoxy-$\alpha$-ethoxyacetophenon
$\alpha,\alpha$-Dibutoxy-4-chloracetophenon
$\alpha,\alpha$-Diethoxy-4-fluoracetophenon
$\alpha,\alpha$-Dimethoxy-4-methylacetophenon

α,α-Dimethoxy-4-methylacetophenon
α,α-Dimethoxypropiophenon
α,α-Diethoxypropiophenon
α,α-Diethoxybutyrophenon
α,α-Dimethoxyisovalerophenon
α,α-Diethoxy-α-cyclohexylacetophenon
α,α-Dipropoxy-4-chlorpropiophenon.

Beispiele für α-Hydroxy- α-Aminoacetophenone sind:
2-Hydroxy-2-methyl-1-phenyl-propanon-1
2-Hydroxy-2-ethyl-1-phenylhexanon-1
1-(4-Dodecylphenyl)-2-hydroxy-2-methylpropanon-1
1-(2,4-Dimethylphenyl)-2-hydroxy-2-methylpropan-1
2-Hydroxy-1-(4-methoxyphenyl)-2-methylpropanon-1
2-Hydroxy-2-methyl-1-phenylbutanon-1
1-Benzoyl-cyclohexanol
2-Dimethylamino-2-methyl-1-phenylpropanon-1
2-Dimethylamino-2-methyl-1-phenylpropanon-1
1-(4-Fluorphenyl)-2-methyl-2-morpholinopentanon-1
2-Methyl-1-(4-Methylthiophenyl)-2-morpholinopentanon-1
2-Dimethylamino-1-(4-methoxyphenyl)-2-methylpropanon-1
2-Dimethylamino-1-(4-methoxyphenyl)-2-methylpropanon-1

Das Photoinitiatorengemisch (b) + (c) kann in Mengen von 0,5-20, vorzugsweise 1 bis 10 Gew.-%, zugegeben werden, bezogen auf die Komponente (a).

Die Wahl des Lösungsmittels und die Konzentration richtet sich hauptsächlich nach der Art der Zusammensetzung und nach dem Beschichtungsverfahren. Die Zusammensetzung wird mittels bekannter Beschichtungsverfahren auf ein Substrat gleichförmig aufgebracht, z.B. durch Tauchen, Rakelbeschichtung, Vorhanggiessverfahren, Elektrophorese, Aufpinseln, Sprayen oder Reverseroll-Beschichtung. Die Auftragsmenge (Schichtdicke) und Art des Substrates (Schichtträger) sind abhängig von gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm; für gedruckte Schaltungen im allgemeinen 1 bis ca. 100 µm. Bei Mitverwendung von Lösungsmitteln werden diese nach dem Beschichten entfernt.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zuzusetzen, die vor allem während der Herstellung der Zusammensetzungen durch Mischen der Komponenten vor einer vorzeitigen Polymerisation schützen sollen. Hierzu werden beispielsweise Hydrochinon, Hydrochinonderivate, p-Methoxyphenol, β-Naphthole oder sterisch gehinderte Phenole wie z.B. 2,6-Di(tert-butyl)-p-kresol verwendet. Weiter können geringe Mengen von UV-Absorbern zugesetzt werden, wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabilität können Kupferverbindungen, wie Kupfernaphthenat, -stearat, oder -octoat, Phosphorverbindungen, wie Triphenylphosphin, Tributylphospin, Triethylphosphit, Triphenylphosphit oder Tribenzylphosphit, quaternäre Ammoniumverbindungen, wie Tetramethylammoniumchlorid oder Trimethyl-benzylammoniumchlorid oder Hydroxylaminderivate, wie z.B. N-Diethylhydroxylamin, zugesetzt werden.

Um die inhibierende Wirkung des Luftsauerstoffs auszuschliessen setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert.

Weitere übliche Zusätze sind Photosensibilisatoren, welche in bestimmten Wellenlängen absorbieren und die absorbierte Energie an die Initiatoren weitergeben oder selbst als zusätzlicher Initiator fungieren. Beispiele hierfür sind vor allem Thioxanthon-, Anthracen-, Anthrachinon- und Cumarinderivate.

Weitere übliche Zusätze sind Beschleuniger von Amin-Typ, die vor allem in pigmentierten Zubereitungen von Bedeutung sind, da sie als Kettenüberträger wirken. Beispiele hierfür sind N-Methyldiethanolamin, Triethylamin, p-Dimethylaminobenzoesäureethylester oder Michler's Keton. Die Wirkung der Amine kann

verstärkt werden durch den Zusatz von aromatischen Ketonen vom Benzophenontyp.

Weitere übliche Zusätze sind Füllstoffe, Pigmente, Farbstoffe und Verarbeitungshilfsmittel, wie z.B. Haft-, Netz- und Verlaufmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Zusammensetzungen auch zur Herstellung von Druckplatten insbesondere Flexodruckplatten. Hierbei werden z.B. Gemische von löslichen linearen Polyamiden oder von Styrol/Butadien-Kautschuk mit photopolymerisierbaren Monomeren, beispielsweise Acrylamiden oder Acrylaten und einem Photoinitiator verwendet. Filme und Platten aus diesen Systemen (nass oder trocken) werden über das Negativ (oder Positiv) der Druckvorlage belichtet und die ungehärteten Anteile anschliessend mit einem Lösungsmittel eluiert.

Ein weiteres Eingsatzgebiet der Photohärtung ist die Metallbeschichtung, beispielsweise bei der Lackierung von Blechen für Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (= Entwickler) entfernt. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Zur Belichtung eignen sich Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonlampen oder photographische Flutlichtlampen. Neuerdings werden auch Laserlichtquellen verwendet. Diese haben den Vorteil, dass keine Photomasken notwendig sind; der gesteuerte Laserstrahl schreibt direkt auf die photohärtbare Schicht.

Die nachfolgenden Beispiele erläutern die Erfindung näher.

## Herstellungsbeispiele

### Beispiele 1-7:

Eine Lösung von 17,3 g Pentafluorbenzol (103 mmol) in 500 ml absolutem Diethylether wird unter Argon bei - 70 °C tropfenweise mit 64,4 ml 1,6 molarer Butyllithium-Hexan-Lösung (103 mmol) versetzt und eine Stunde bei -70 °C gerührt. Anschliessend werden 17,7 g $(Me_3Sicp)_2TiCl_2$ (50 mmol) in einer Portion zugegeben, die Reaktionsmischung langsam auf Raumtemperatur erwärmt und noch drei Stunden bei Raumtemperatur gerührt. Danach wird filtriert und der Rückstand mehrmals mit Ether extrahiert. Die vereinigten Filtrate werden im Vakuum eingedampft und der verbleibende orangerote Feststoff mit Ether über Aluminiumoxid (Woelm, neutral) chromatographiert. Das orangefarbene Eluat wird bei Raumtemperatur bis zur Sättigung eingeengt und dann auf -78 °C gekühlt. Die sich bildenden orangefarbenen Kristalle von $(Me_3Sicp)_2Ti(C_6F_5)_2$ werden im Hochvakuum getrocknet. Ausbeute: 23,6 g (72 %).

Analog wird in den Beispielen 2-7 verfahren. Chromatographie und Kristallisation der Produkte erfolgt in den Beispielen 5-7 mit einer Mischung Ether/Hexan = 1:1.

Reaktionsbedingungen und Resultate sind in den Tabellen 1 und 2 zusammengestellt. Darin bedeuten Cp Cyclopentadienyl und Me Methyl. Alle Produkte sind orangefarben und sind unter Lichtausschluss an der Luft stabil.

Tabelle 1 - Edukte

| Beispiel | Titanverbindung | Fluoraromat | Butyllithium 1,6 m in Hexan | Lösungmittel |
|---|---|---|---|---|
| 1 | $(Me_3SiCp)_2TiCl_2$ 17,7 g | $C_6F_5H$ 17,3 g | 64,4 ml | Ether 500 ml |
| 2 | $(Me_3SiCp)CpTiCl_2$ 16,1 g | $C_6F_5H$ 17,3 g | 64,4 ml | Ether 500 ml |
| 3 | $(Me_3SiCp)_2TiCl_2$ 5,9 g | 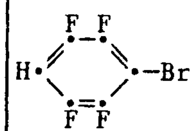 7,1 g | 19,4 ml | Ether 150 ml |
| 4 | $(Me_3SiCp)_2TiCl_2$ 5,9 g | 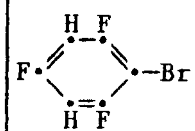 6,6 g | 19,4 ml | Ether 150 ml |
| 5 | $(Me_3SiCp)CpTiCl_2$ 3,2 g | 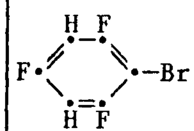 5,3 g | 15,6 ml | Ether 100 ml |
| 6 | $(Me_3SiCp)_2TiCl_2$ 5,9 g | 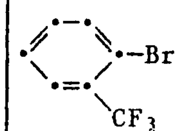 3,6 g | 10,0 ml | Ether 150 ml |
| 7 | $(Me_3SiCp)CpTiCl_2$ 9,6 g | 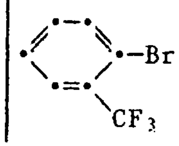 6,9 g | 19,4 ml | Ether 300 ml |

Tabelle 2 - Produkte

| Beispiel | Formel | Ausbeute % | Schmelzpunkt/°C | Analyse % Ti ber. | Analyse % Ti gef. |
|---|---|---|---|---|---|
| 1 | $(Me_3Sicp)_2Ti(C_6F_5)_2$ | 72 | 190 | 7,30 | 7,27 |
| 2 | $(Me_3Sicp)cpTi(C_6F_5)_2$ | 80 | 175 | 8,20 | 8,09 |
| 3 | $(Me_3Sicp)_2Ti(p\text{-}HC_6F_4)_2$ | 50 | 150 | 7,72 | 7,76 |
| 4 | $(Me_3Sicp)_2Ti(2,4,6\text{-}F_3C_6H_2)_2$ | 53 | 146 | 8,19 | 8,02 |
| 5 | $(Me_3Sicp)cpTi(2,4,6\text{-}F_3C_6H_2)_2$ | 59 | 175 | 9,35 | 9,08 |
| 6 | $(Me_3Sicp)_2Ti(o\text{-}CF_3C_6H_4)Cl$ | 44 | 111 | 9,52 | 9,55 |
| 7 | $(Me_3Sicp)cpTi(o\text{-}CF_3C_6H_4)Cl$ | 67 | 61 | 11,12 | 10,90 |

Beispiele 8-24:

Unter Argon wird die jeweils in Tabelle 3 angegebene Menge Fluoraromat im jeweiligen Lösungsmittel gelöst, bei -70 °C tropfenweise mit der entsprechenden Menge 1,6 molarer Butyllithium-Hexan-Lösung versetzt und noch eine Stunden bei -70 °C gerührt. Anschliessend wird die angegebene Menge Titanocendichlorid in einer Portion zugegeben, die Reaktionsmischung langsam auf Raumtemperatur erwärmt und noch drei Stunden bei Raumtemperatur gerührt. Danach wird im Vakuum vollständig eingedampft, der Rückstand mit Dichlormethan oder Chloroform extrahiert und die Extrakte filtriert. Das Filtrat wird erneut eingedampft und der verbleibende Rückstand wie in Tabelle 4 angegeben gereinigt.

Die Produkte haben gelb-orange bis rot-orange Farbe. Mit Ausnahme des Beispiels 21, das ein Oel ist, sind die Produkte kristallin. Alle Produkte sind unter Lichtausschluss stabil und nicht luftempfindlich.

In den folgenden Tabellen bedeuten Cp Cyclopentadienyl, Ph Phenyl und Me Methyl. Die chromatographische Reinigung geschieht an Säulen aus Aluminiumoxid (Woelm) neutral (= $Al_2O_3$) oder aus Kieselgel 60 (Merck) (= $SiO_2$).

Tabelle 3 - Edukte

| Bsp. | Titanverbindung | | Fluoraromat | | Butyllithium 1,6 m in Hexan | Lösungsmittel |
|---|---|---|---|---|---|---|
| 8 | $[(Me_3Si)_2Cp]CpTiCl_2$ | 7,9 g | Pentafluorbenzol | 6,9 g | 26,2 ml | Ether 250 ml |
| 9 | $[(Me_3Si)_3Cp]CpTiCl_2$ | 9,4 g | Pentafluorbenzol | 6,7 g | 26,2 ml | Ether 250 ml |
| 10 | $[(n-C_6H_{13})_3SiCp]_2TiCl_2$ | 5,0 g | Pentafluorbenzol | 2,1 g | 8,0 ml | Ether 120 ml |
| 11 | $(n-C_8C_{17}SiMe_2Cp)CpTiCl_2$ | 8,4 g | Pentafluorbenzol | 6,9 g | 26,2 ml | Ether 200 ml |
| 12 | $(n-C_8H_{17}SiMe_2Cp)_2TiCl_2$ | 10,0 g | Pentafluorbenzol | 5,7 g | 21,9 ml | Ether 170 ml |
| 13 | $[(n-C_8H_{17}SiMe_2)_2Cp]CpTiCl_2$ | 11,8 g | Pentafluorbenzol | 6,7 g | 25,6 ml | Ether 200 ml |
| 14 | $[(n-C_{18}H_{37}SiMe_2Cp)_2TiCl_2$ | 4,3 g | Pentafluorbenzol | 1,7 g | 6,4 ml | Ether 50 ml |
| 15 | $(SiMe_2Cp)_2TiCl_2$ | 10,7 g | Pentafluorbenzol | 6,9 g | 26,2 ml | Ether 200 ml |
| 16 | $(ClCH_2SiMe_2Cp)_2TiCl_2$ | 4,6 g | Pentafluorbenzol | 3,4 g | 12,5 ml | Ether 150 ml |
| 17 | $(Ph_3SiCp)_2TiCl_2$ | 5,6 g | Pentafluorbenzol | 2,5 g | 7,1 ml | Ether 100 ml |

Tabelle 3 - Edukte (Fortsetzung)

| Bsp. | Titanverbindung | | Fluoraromat | | Butyllithium 1,6 m in Hexan | Lösungsmittel |
|---|---|---|---|---|---|---|
| 18 | $[(C_2H_5O)_3SiCp]_2TiCl_2$ | 12,0 g | Pentafluorbenzol | 8,5 g | 32,8 ml | Ether 250 ml |
| 19 | $(Me_3SiOSiMe_2Cp)_2TiCl_2$ | 0,9 g | Pentafluorbenzol | 0,6 g | 2,1 ml | Ether 20 ml |
| 20 | $(Me_3SiCp)MeCpTiCl_2$ | 6,7 g | Pentafluorbenzol | 6,7 g | 25,0 ml | Ether 200 ml |
| 21 | $(Me_3SiCp)_2TiCl_2$ | 7,9 g | 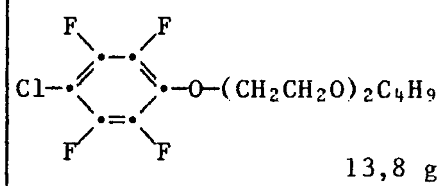 | 13,8 g | 25,0 ml | Ether 200 ml |
| 22 | $(Me_3SiCp)_2TiCl_2$ | 7,9 g | m-Difluorbenzol | 4,7 g | 26,2 ml | THF 200 ml |
| 23 | $(Me_3SiCp)CpTiCl_2$ | 5,8 g | m-Difluorbenzol | 4,7 g | 26,2 ml | THF 200 ml |
| 24 | $[(Me_3Si)_2Cp]CpTiCl_2$ | 7,1 g | m-Difluorbenzol | 4,6 g | 26,2 ml | THF 200 ml |

Tabelle 4 - Produkte

| Bsp. | Formel | Reinigung | Smp./ °C |
|---|---|---|---|
| 8 | $[(Me_3Si)_2Cp]CpTi(C_6F_5)_2$ | Chromatogr. ($Al_2O_3$, Ether) | 162 |
| 9 | $[(Me_3Si)_3Cp]CpTi(C_6F_5)_2$ | Chromatogr. ($Al_2O_3$, Hexan:Ether = 9:1) | 166 |
| 10 | $[(n\text{-}C_6H_{13})_3SiCp]_2Ti(C_6F_5)_2$ | Chromatogr. ($SiO_2$, Hexan ) | 75 |
| 11 | $(n\text{-}C_8H_{17}SiMe_2Cp)CpTi(C_6F_5)_2$ | Chromatogr. ($Al_2O_3$, Hexan:Ether = 8:2) | 92 |
| 12 | $(n\text{-}C_8H_{17}SiMe_2Cp)_2Ti(C_6F_5)_2$ | Chromatogr. ($Al_2O_3$, Hexan) | 76 |
| 13 | $[(n\text{-}C_8H_{17}SiMe_2)_2Cp]CpTi(C_6F_5)_2$ | Chromatogr. ($Al_2O_3$, Hexan:Ether = 9:1) | 61 |
| 14 | $(n\text{-}C_{18}H_{37}SiMe_2Cp)_2Ti(C_6F_5)_2$ | Chromatogr. ($SiO_2$, Hexan) | 66 |
| 15 | $((CH_3)CHC(CH_3)\text{-}SiMe_2Cp)_2Ti(C_6F_5)_2$ | Chromatogr. ($Al_2O_3$, Hexan) | 186 |
| 16 | $(ClCH_2SiMe_2Cp)_2Ti(C_6H_5)_2$ | Umkristallisation (Hexan) | 161 |
| 17 | $(Ph_3SiCp)_2Ti(C_6H_5)_2$ | Umkristallisation ($CH_2Cl_2$/Hexan) | 216 |
| 18 | $[(C_2H_5O)_3SiCp]_2Ti(C_6F_5)_2$ | Umkristallisation (Pentan) | 78 |
| 19 | $(Me_3SiOSiMe_2Cp)_2Ti(C_6F_5)_2$ | Chromatogr. ($SiO_2$, Hexan) | 136 |
| 20 | $(Me_3SiCp)MeCpTi(C_6F_5)_2$ | Umkristallisation (Ether:Hexan = 1:3) | 159 |

Tabelle 4 - Produkte (Fortsetzung)

| Bsp. | Formel | Reinigung | Smp./ °C |
|---|---|---|---|
| 21 | $(Me_3SiCp)_2Ti$ 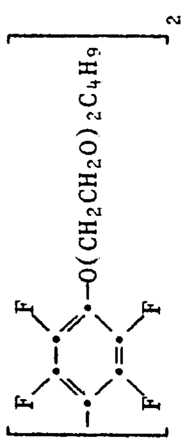 | Chromatogr. ($SiO_2$, Hexan:Ether = 10:1) | Oel |
| 22 | $(Me_3SiCp)_2Ti$ 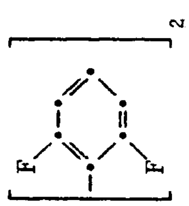 | Chromatogr. ($Al_2O_3$, Hexan:Ether = 1:1) | 153 |
| 23 | $(Me_3SiCp)CpTi$ 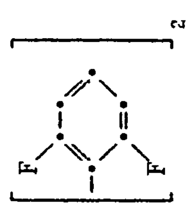 | Chromatogr. ($Al_2O_3$, Hexan:Ether = 1:1) | 174 |
| 24 | $[(Me_3Si)_2Cp]CpTi$ 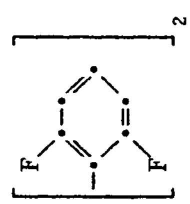 | Chromatogr. ($Al_2O_3$, Hexan:Ether = 9:1) | 105 |

Applikationsbeispiele

Beispiel 25: Photohärtung eines Acrylat-Gemisches

Es wird eine photohärtbare Zusammensetzung hergestellt durch Mischen der folgenden Komponenten:

50 Teile eins Oligourethan-acrylates (Actilan® AJ 20, SNPE, Frankreich),

20 Teile Trimethylolpropan-triacrylat

15 Teile Tripropylenglykol-diacrylat
15 Teile N-Vinylpyrrolidon
0,5 Teile eines Verlaufshilfsmittels auf Silicon-Basis (BYK® 300, Byk-Mallinckrodt, BRD)

Portionen dieser Zusammensetzung werden mit den in der folgenden Tabelle angegebenen Menge an Photoinitiator oder Initiatorgemischen vermischt. Bei den Initiatorgemischen handelt es sich um Lösungen eines Titanocens in einem flüssigen Initiator vom Ketal-Typ der Formel A

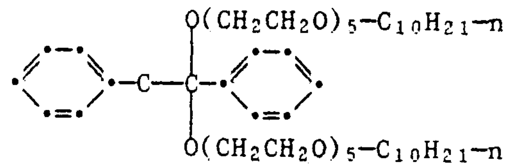

A

Alle Operationen werden unter Rotlicht oder Gelblicht ausgeführt.

Die mit Initiator versetzten Proben werden in einer Stärke von 100 μm auf Aluminiumbleche (10 x 15 cm) aufgetragen. Auf die flüssige Schicht wird eine 76 μm dicke Polyesterfolie gelegt und auf diese ein standardisiertes Testnegativ mit 21 Stufen verschiedener optischer Dichte (Stauffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 5 Sekunden und in einer zweiten Testreihe 10 Sekunden und in einer dritten Testreihe 15 Sekunden. Nach der Belichtung werden die Folien und die Maske entfernt, die belichtete Schicht in einem Ethanolbad 15 Sekunden entwickelt und anschliessend bei 60 °C 5 Min getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 5 dargestellt.

Tabelle 5

| Titanocen-Initiator | Ketal-Initiator | Zahl der abgebildeten Stufen nach Belichtung 5s | 10s | 15s |
|---|---|---|---|---|
| 0,2 % Bsp. 1 | - | 12 | 14 | 16 |
| 0,2 % Bsp. 1 | 1,8 % A | 12 | 14 | 16 |
| 0,2 % Bsp. 3 | - | 11 | 13 | 15 |
| 0,2 % Bsp. 3 | 1,8 % A | 13 | 15 | 17 |
| 0,2 % Bsp. 4 | - | 12 | 14 | 16 |
| 0,2 % Bsp. 4 | 1,8 % A | 12 | 14 | 16 |
| 0,2 % Bsp. 5 | - | 13 | 15 | 17 |
| 0,2 % Bsp. 5 | 1,8 % A | 14 | 16 | 17 |
| 0,2 % Bsp. 6 | - | 8 | 10 | 11 |
| 0,2 % Bsp. 6 | 1,8 % A | 8 | 10 | 12 |

Beispiel 26: Photohärtung eines Acrylat-Gemisches

Folgende Komponenten werden vermischt:

| | |
|---|---|
| 50 Teile | eins Oligourethan-acrylates (Actilan® 20, SNPE, Frankreich), |
| 10 Teile | Trimethylolpropan-triacrylat |
| 10 Teile | Dipentaerythrit-pentaacrylat |
| 15 Teile | Tripropylenglykol-diacrylat |
| 15 Teile | N-Vinylpyrrolidon |
| 0,30 Teile | eines Verlaufshilfsmittels auf Silicon-Basis (BYK® 300, Byk-Mallinckrodt, BRD |

Dann werden die in Tabelle 6 angegebenen Photoinitiatoren zugesetzt. Als Co-Initiator wird das in Beispiel 25 definierte flüssige Ketal A verwendet.

Die mit Initiator versetzten Proben werden in einer Schichtdicke von 100 µm auf Aluminium-Folie (200 µm) aufgebracht und wie in Beispiel 25 beschrieben unter einem 21-Stufen-Stoufferkeil belichtet. Nach jeweils 5, 10 und 20s Belichtung werden die Proben mit Ethanol im Ultraschallbad 10s entwickelt und anschliessend getrocknet. In Tabelle 6 wird die höchste Stufe, die komplett und klebefrei ausgebildet ist, angegeben.

Tabelle 6

| Titanocen-Initiator | Ketal-Initiator | Zahl der abgebildeten Stufen nach 5s | 10s | 20s Belichtung |
|---|---|---|---|---|
| 0,2 % Bsp. 8 | - | 10 | 13 | 15 |
| 0,2 % Bsp. 8 | 1,8 % A | 11 | 14 | 15 |
| 0,2 % Bsp. 9 | - | 8 | 10 | 12 |
| 0,2 % Bsp. 9 | 1,8 % A | 8 | 10 | 12 |
| 0,2 % Bsp. 10 | - | 6 | 8 | 10 |
| 0,2 % Bsp. 10 | 1,8 % A | 8 | 10 | 12 |
| 0,2 % Bsp. 11 | - | 11 | 14 | 15 |
| 0,2 % Bsp. 11 | 1,8 % A | 12 | 15 | 16 |
| 0,2 % Bsp. 12 | - | 8 | 11 | 12 |
| 0,2 % Bsp. 12 | 1,8 % A | 8 | 11 | 12 |
| 0,2 % Bsp. 13 | - | 10 | 13 | 16 |
| 0,2 % Bsp. 13 | 1,8 % A | 11 | 13 | 16 |
| 0,2 % Bsp. 14 | - | 5 | 7 | 9 |
| 0,2 % Bsp. 14 | 1,8 % A | 7 | 9 | 13 |
| 0,2 % Bsp. 15 | - | 8 | 10 | 12 |
| 0,2 % Bsp. 15 | 1,8 % A | 9 | 11 | 13 |
| 0,2 % Bsp. 18 | - | 11 | 13 | 15 |
| 0,2 % Bsp. 18 | 1,8 % A | 11 | 13 | 15 |

Tabelle 6 (Fortsetzung)

| Titanocen-Initiator | Ketal-Initiator | Zahl der abgebildeten Stufen nach Belichtung 5s | 10s | 20s |
|---|---|---|---|---|
| 0,2 % Bsp. 22 | - | 11 | 14 | 15 |
| 0,2 % Bsp. 22 | 1,8 % A | 11 | 14 | 15 |
| 0,2 % Bsp. 23 | - | 12 | 15 | 16 |
| 0,2 % Bsp. 23 | 1,8 % A | 13 | 15 | 17 |
| 0,2 % Bsp. 24 | - | 11 | 14 | 15 |
| 0,2 % Bsp. 24 | 1,8 % A | 12 | 14 | 16 |

Beispiel 27:

Es wird eine Zusammensetzung hergestellt aus:

| | |
|---|---|
| 150 Teilen | einer 30%igen Lösung eines Styrol-Monomethylmaleinat-Copolymers (Scripset® 540, Monsanto Chem., USA) in Aceton |
| 48 Teilen | Trimethylolpropan-triacrylat |
| 7 Teilen | Polyethylenglykol-diacrylat |
| 0,08 Teilen | Kristallviolett |

Daraus werden Proben bereitet durch Zumischen von 0,3 % der in Tabelle 7 aufgeführten Titanocen-Initiatoren, sowie 1,7 % des Co-Initiators B. Dieser besteht zu 50 % aus dem α-Hydroxyacetophenon B′

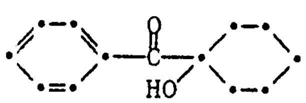

B'

und 50 % Benzophenon.

Die Proben werden in eine Schichtdicke von 150 µm auf Aluminium-Folien aufgetragen, was einer Trockenschichtdicke von etwa 50 µm entspricht. Die Belichtung unter einem 21-Stufen-Keil geschieht wie in Beispiel 25 beschrieben. Die Entwicklung geschieht in einem Entwicklerbad der folgenden Zusammensetzung:

| | |
|---|---|
| 15 Teile | Natriummetasilikat |
| 0,16 Teile | Kaliumhydroxid |
| 3 Teile | Polyethylenglykol 6000 |
| 0,5 Teile | Lävulinsäure |
| 1000 Teile | Wasser |

Tabelle 7 gibt die maximale Zahl der abgebildeten Stufen nach 20, 40 und 60s Belichtung an.

Tabelle 7

| Titanocen-Initiator | Ketal-Initiator | Zahl der abgebildeten Stufen nach 5s | 10s | 15s Belichtung |
|---|---|---|---|---|
| 0,2 % Bsp. 16 | - | 14 | 16 | 19 |
| 0,2 % Bsp. 16 | 1,7 % B | 13 | 15 | 18 |
| 0,2 % Bsp. 17 | - | 10 | 12 | 14 |
| 0,2 % Bsp. 17 | 1,7 % B | 10 | 12 | 13 |
| 0,2 % Bsp. 19 | - | 14 | 16 | 19 |
| 0,2 % Bsp. 19 | 1,7 % B | 12 | 17 | 19 |
| 0,2 % Bsp. 20 | - | 15 | 18 | 21 |
| 0,2 % Bsp. 20 | 1,7 % B | 14 | 16 | 18 |
| 0,2 % Bsp. 21 | - | 13 | 15 | 17 |
| 0,2 % Bsp. 21 | 1,7 % B | 16 | 16 | 17 |

Beispiel 28:

Eine photohärtbare Zusammensetzung wird durch Vermischen der folgenden Komponenten bereitet:

| | |
|---|---|
| 47,3 Teile | eines thermoplastischen Polyacrylates mit Carboxylgruppen (Carboset® 525, B.F. Goodrich, USA) |
| 10,7 Teile | Hexamethoxymethylmelamin |
| 37,7 Teile | Pentaerythrit-triacrylat |
| 4,3 Teile | Polyvinylpyrrolidon |

100 g dieser Zusammensetzung werden mit 0,5 g Irgalithgrün® GLN (Ciba-Geigy AG) versetzt und mit 30 g Methanol und 319 g Methylenchlorid verdünnt.

Von dieser Lösung werden Proben bereitet durch Zusatz von 0,3 % der in Tabelle 8 aufgeführten Titanocen-Initiatoren und 1,7 % des flüssigen Keton-Initiatorgemisches B (siehe Beispiel 27), jeweils bezogen auf die in der Lösung enthaltenen Feststoffe.

Die Proben werden in einer Nass-Schichtdicke von 200 µm (~ 45µm Trockenschichtdicke) auf eine 200 µm starke Aluminium-Folie aufgebracht und das Lösungsmittel bei 60 °C/15 min abgedampft. Die Belichtung unter dem Stufenkeil geschieht wie in Beispiel 25 beschrieben. Die Entwicklung der belichteten Proben geschieht im Ultraschallbad mit der in Beispiel 27 beschriebenen alkalischen Entwicklerlösung. Tabelle 8 gibt die maximale Zahl der abgebildeten Stufen nach 20, 40 und 60s Belichtung an.

Tabelle 8

| Titanocen-Initiator | Ketal-Initiator | Zahl der abgebildeten Stufen nach Belichtung 5s | 10s | 15s |
|---|---|---|---|---|
| 0,3 % Bsp. 16 | - | 14 | 16 | 20 |
| 0,3 % Bsp. 16 | 1,7 % B | 13 | 15 | 17 |
| 0,3 % Bsp. 17 | - | 12 | 14 | 16 |
| 0,3 % Bsp. 17 | 1,7 % B | 12 | 15 | 17 |
| 0,3 % Bsp. 19 | - | 13 | 14 | 20 |
| 0,3 % Bsp. 19 | 1,7 % B | 13 | 15 | 18 |
| 0,3 % Bsp. 20 | - | 14 | 17 | 19 |
| 0,3 % Bsp. 20 | 1,7 % B | 13 | 15 | 17 |
| 0,3 % Bsp. 21 | - | 10 | 13 | 15 |
| 0,3 % Bsp. 21 | 1,7 % A | 12 | 14 | 16 |

## Patentansprüche

1. Titanocene der Formel I

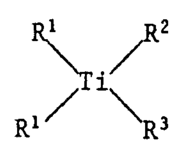

(I),

worin beide $R^1$ unabhängig voneinander gegebenenfalls durch $C_1$-$C_{18}$-Alkyl, $C_2$-$C_{18}$-Alkenyl, Chlor, Phenyl oder Cyclohexyl substituiertes Cyclopentadienyl$^{\ominus}$ oder beide $R^1$ zusammen einen substituierten Rest der Formel II bedeuten,

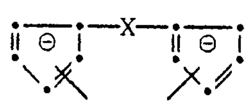

(II)

worin X $(CH_2)_n$ mit n = 1, 2 oder 3, gegebenenfalls durch Phenyl substituiertes Alkyliden mit 2 bis 12 C-Atomen oder Cycloalkyliden mit 5 bis 7 Ringkohlenstoffatomen bedeutet,
$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch F, $CF_3$, $C_2F_5$, $CF_2Cl$ oder $CF_2CH_3$ substituiert ist, und ausserdem durch eine oder mehrere der Gruppen Halogen, $C_1$-$C_{12}$-Alkyl, $C_1$-$C_4$-Alkoxy, $C_2$-$C_{10}$-Alkoxycarbonyl, Aminocarbonyl mit bis zu 12 C-Atomen

oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, oder, wenn $R^2$ einen durch F substituierten aromatischen Ring bedeutet, dieser mindestens einen gegebenenfalls veretherten oder veresterten Polyoxaalkylenrest substituiert sein kann, wobei dieser Rest entweder direkt oder über eine Brückengruppe an den aromatischen Ring gebunden sein kann, oder $R^2$ und $R^3$ zusammen einen Rest der Formel III bedeuten,

—Q—Y—Q— (III)

in dem Q einen carbocyclischen aromatischen Ring bedeutet, der in 2-Stellung zur Y-Gruppe an das Titanatom gebunden ist und in 3-Stellung durch Fluor substituiert ist, Y Methylen, gegebenenfalls durch Phenyl substituiertes $C_2$-$C_{12}$-Alkyliden, $C_5$-$C_7$-Cycloalkyliden, eine Gruppe -$NR^5$-, -O-, -S-, -SO-, -$SO_2$-, -CO-, -$SiR^4_2$ - oder -$SnR^4_2$ - bedeutet und $R^5$ Wasserstoff, $C_1$-$C_{12}$-Alkyl, Cyclohexyl, Phenyl, Tolyl oder Benzyl bedeutet, und die Reste $R^4$ unabhängig voneinander $C_1$-$C_{12}$-Alkyl, Cyclohexyl, Phenyl oder Benzyl sind, $R^3$ eine der für $R^2$ gegebenen Bedeutungen hat oder $C_2$-$C_{12}$-Alkinyl, unsubstituiertes oder im Phenylrest durch Halogen oder $C_1$-$C_4$-Alkyl substituiertes Phenylalkinyl mit 2-5 C-Atomen in Alkinrest oder eine Gruppe -$SiR^4_3$ , -$SnR^4_3$ , -$N_3$ oder -CN bedeutet, oder $R^3$ zusätzlich Halogen, -NCO oder -NCS ist, wenn $R^2$ einen durch -$CF_3$, -$C_2F_5$, $CF_2Cl$ oder $CF_3CH_3$ substituierten aromatischen Ring darstellt,

wobei die Titanocen dadurch gekennzeichnet sind, dass mindestens ein $R^1$ durch mindestens eine Gruppe der Formeln IV oder V

$(R^6)_3Z-$ (IV)

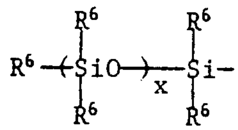 (V)

substituiert ist, worin Z für Si oder Ge steht, x 1, 2 oder 3 bedeutet, und jedes $R^6$ unabhängig lineares oder verzweigtes $C_1$-$C_{18}$-Alkyl, $C_1$-$C_4$-Halogenalkyl, Phenyl, $C_1$-$C_{18}$-Alkoxy oder $C_1$-$C_{18}$-Alkoxymethyl darstellt.

2. Titanocene gemäss Anspruch 1, dadurch gekennzeichnet, dass in Formel I ein $R^1$ ein unsubstituiertes Cyclopentadienyl ist und das andere $R^1$ bis zu 3 Substituenten enthält, oder jedes $R^1$ substituiertes Cyclopentadienyl ist, wobei mindestens 1 Substituent der Formel IV oder V entspricht.

3. Titanocene gemäss Anspruch 1, dadurch gekennzeichnet, dass x für 1 und Z für Si steht.

4. Titanocene gemäss Anspruch 1, dadurch gekennzeichnet, dass $R^6$ $C_1$-$C_4$-Alkyl, $C_1$-$C_4$-Halogenalkyl, $C_1$-$C_4$-Alkoxy oder Phenyl ist.

5. Titanocene gemäss Anspruch 1, dadurch gekennzeichnet, dass in Formel IV ein $R^6$ $C_1$-$C_{18}$-Alkyl, $C_1$-$C_4$-Halogenalkyl, $C_1$-$C_4$-Alkoxy oder Phenyl und die anderen beiden $R^6$ Methyl sind.

6. Titanocene gemäss Anspruch 1, dadurch gekennzeichnet, dass die Gruppe der Formel IV Trimethylsilyl ist.

7. Titanocene gemäss Anspruch 1, dadurch gekennzeichnet, dass ein $R^1$ ein durch die Gruppen der Formeln IV oder V substituiertes Cyclopentadienylanion ist und das andere $R^1$ die gleiche Bedeutung hat, oder ein Cyclopentadienyl- oder Methylcyclopentadienylanion ist.

8. Titanocene gemäss Anspruch 1, dadurch gekennzeichnet, dass $R^2$ und $R^3$ in Formel 1 gleich sind und einen 6-gliedrigen carbocyclischen oder 5- oder 6-gliedrigen heterocyclischen aromatischen Ring bedeuten, der in einer oder beiden Orthostellungen zur Metallkohlenstoffbindung durch F oder in einer Orthostellung durch $CF_3$, $C_2F_5$,$CF_2Cl$ oder $CF_2CH_3$ substituiert ist und weitere wie in Anspruch 1 definierte Substituenten enthalten kann.

**9.** Titanocene gemäss Anspruch 1, dadurch gekennzeichnet, dass $R^2$ und $R^3$ 2,6-Difluorphen-1-yl bedeuten, das 1 bis 3 wie in Anspruch 1 definierte Substituenten enthalten kann.

**10.** Titanocene gemäss Anspruch 9, dadurch gekennzeichnet, dass $R^2$ und $R^3$ eine Rest der Formel

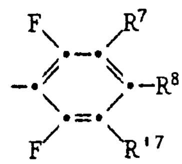

bedeuten, worin $R^7$, $R'^7$ und $R^8$ unabhängig voneinander H, F, Cl oder Br bedeuten, oder $R^7$ und $R'^7$ unabhängig voneinander je H, F, Cl oder Br bedeuten und $R^8$ eine primäre, sekundäre oder tertiäre Amino-oder Aminoalkylgruppe mit bis zu 20 C-Atomen oder eine quartäre Ammonium- oder Ammoniumalkylgruppe mit bis zu 30 C-Atomen ist, oder $R^8$ ein gegebenenfalls veresterter oder veretherter Polyoxaalkylenrest ist, der direkt oder über eine Brückengruppe an den Phenylring gebunden ist.

**11.** Titanocene gemäss Anspruch 1, dadurch gekennzeichnet, dass $R^2$ mindestens einen gegebenenfalls veretherten oder veresterten Polyoxaalkylenrest enthält, der direkt oder über eine Brückengruppe an den Arylrest gebunden ist.

**12.** Titanocene gemäss Anspruch 11, dadurch gekennzeichnet, dass der Polyoxaalkylenrest der Formel

$$-(C_zH_{2z}O)_o-R^9 ,$$

entspricht, worin z eine Zahl von 2-6, o eine Zahl von 1 bis 20 und $R^9$ H oder $C_1$-$C_{18}$-Alkyl darstellen.

**13.** Titanocene gemäss Anspruch 1, dadurch gekennzeichnet, dass $R^2$ eine Rest der Formel

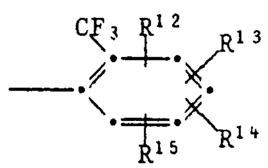

bedeutet, worin $R^{12}$, $R^{13}$, $R^{14}$ und $R^{15}$ unabhängig voneinander ein Wasserstoffatom, $-CF_3$, Brom, Chlor oder Fluor bedeuten und $R^3$ die Bedeutung von $R^2$ hat oder für Halogen oder $-N_3$, -CN, -NCO oder -NCS steht.

**14.** Titanocene gemäss Anspruch 13, dadurch gekennzeichnet, dass $R^{12}$, $R^{13}$ und $R^{14}$ Wasserstoff sind, $R^{15}$ in Orthostellung zur Metall-Bindung steht und Fluor oder Wasserstoff bedeutet.

**15.** Titanocene gemäss Anspruch 13, dadurch gekennzeichnet, dass $R^3$ für F, Cl, Br, $N_3$, CN, NCO oder NCS steht.

**16.** Titanocene gemäss Anspruch 1, dadurch gekennzeichnet, dass es sich um Bis-(trimethylsilylcyclopentadienyl)-bis(pentafluorphenyl)-titan, Bis(trimethylsilylcyclopentadienyl)-bis[4-(1′,4′,7′-trioxaundecyl)-2,3,5,6-tetrafluorphenyl]-titan, Bis(trimethylsilylcyclopentadienyl)-o-trifluormethylphenyl-titanchlorid oder Bis(trimethylsilylcyclopentadienyl)-bis[3-(1′,4′,7′-trioxahendecyl)-2,6-difluorphenyl]-titan handelt.

**17.** Verfahren zur Herstellung von Titanocenen der Formel I gemäss Anspruch 1, dadurch gekennzeichnet, dass man 1 Mol einer Verbindung der Formel VI

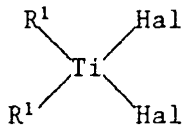

(VI)

worin $R^1$ die in Anspruch 1 angegebene Bedeutung hat und Hal für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ und $R^3$ die in Anspruch 1 angegebene Bedeutung haben.

**18.** Durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I nach Anspruch 1 als Photoinitiator.

**19.** Zusammensetzung gemäss Anspruch 18, dadurch gekennzeichnet, dass zusätzlich mindestens ein weiterer Photoinitiator (c) enthalten ist.

**20.** Zusammensetzung gemäss Anspruch 19, enthaltend als Komponente (c) ein Benzilketal, ein 4-Aroyl-1,3-dioxolan, ein Dialkoxyacetophenon, ein α-Hydroxy- oder α-Aminoacetophenon oder Mischungen davon.

**21.** Beschichtetes Substrat, das auf mindestens einer Oberfläche mit einer Zusammensetzung gemäss Anspruch 18 oder 19 beschichtet ist.

**22.** Verfahren zur photographischen Herstellung von Reliefabbildungen, dadurch gekennzeichnet, dass man ein beschichtetes Substrat gemäss Anspruch 21 bildmässig belichtet und die unbelichteten Anteile danach mit einem Lösungsmittel entfernt.

**23.** Verwendung von Titanocenen der Formel I gemäss Anspruch 1 als Photoinitiatoren für die Photopolymerisation von nicht flüchtigen, monomeren, oligomeren oder polymeren Verbindungen mit mindestens einer polymerisierbaren ethylenisch ungesättigten Doppelbindung.

**24.** Flüssiges Photoinitiatorengemisch, enthaltend einen Photoinitiator aus der Klasse der Benzilketale, 4-Aroyl-1,3-dioxolane, ein Dialkoxyacetophenone, α-Hydroxyacetophenone, α-Aminoacetophenone oder Mischungen hiervon, und ein Titanocen der Formel I gemäss Anspruch 1.

**25.** Verwendung einer Zusammensetzung gemäss Anspruch 19 zur Herstellung von Lacken, Druckfarben, Druckplatten, Resistmaterialien sowie als Bildaufzeichnungsmaterial.

## Claims

**1.** A titanocene of the formula I

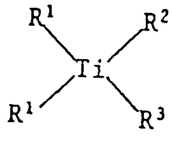

(I)

in which the two radicals $R^1$ independently of one another are cyclopentadienyl$^{\ominus}$ which is unsubstituted or substituted by $C_1$-$C_{18}$alkyl, $C_2$-$C_{18}$alkenyl, chlorine, phenyl or cyclohexyl, or the two radicals $R^1$ together are a substituted radical of the formula II

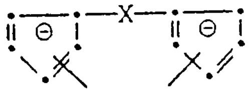

(II)

in which X is $(CH_2)_n$, where n = 1, 2 or 3, alkylidene which has 2 to 12 C atoms and is unsubstituted or substituted by phenyl, or cycloalkylidene with 5 to 7 ring carbon atoms, $R^2$ is a 6-membered carbocyclic or 5- or 6-membered heterocyclic aromatic ring which is substituted by F, $CF_3$, $C_2F_5$, $CF_2Cl$ or $CF_2CH_3$ in at least one of the two ortho-positions relative to the metal-carbon bond, and furthermore can be substituted by one or more of the groups halogen, $C_1$-$C_{12}$alkyl, $C_1$-$C_4$alkoxy, $C_2$-$C_{10}$alkoxycarbonyl and aminocarbonyl with up to 12 C atoms, or by a primary, secondary or tertiary amino or aminoalkyl group with up to 20 C atoms or a quaternary ammonium or ammoniumalkyl group with up to 30 C atoms, or, if $R^2$ is an aromatic ring substituted by F, this can be substituted by at least one polyoxaalkylene radical which is free or etherified or esterified, it being possible for this radical to be bonded to the aromatic ring either directly or via a bridge group, or $R^2$ and $R^3$ together are a radical of the formula III

-Q-Y-Q- (III)

in which Q is a carbocyclic aromatic ring which is bonded to the titanium atom in the 2-position relative to the Y group and is substituted by fluorine in the 3-position, Y is methylene, $C_2$-$C_{12}$alkylidene which is unsubstituted or substituted by phenyl, $C_5$-$C_7$cycloalkylidene or a group $-NR^5-$, -O-, -S-, -SO-, $-SO_2$, -CO-, $-SiR^4_2$ -or $-SnR^4_2$ - and $R^5$ is hydrogen, $C_1$-$C_{12}$alkyl, cyclohexyl, phenyl, tolyl or benzyl, and the radicals $R^4$ independently of one another are $C_1$-$C_{12}$alkyl, cyclohexyl, phenyl or benzyl, $R^3$ has one of the meanings given for $R^2$ or is $C_2$-$C_{12}$alkynyl, phenylalkynyl which has 2-5 C atoms in the alkyne radical and is unsubstituted or substituted by halogen or $C_1$-$C_4$alkyl in the phenyl radical, or is a group $-SiR^4_3$ , $-SnR^4_3$ , in which the radicals $R^4$ are as defined above, $-N_3$ or -CN, or $R^3$ is additionally halogen, -NCO or -NCS, if $R^2$ is an aromatic ring which is substituted by $-CF_3$, $-C_2F_5$, $CF_2Cl$ or $CF_3CH_3$, wherein, in this titanocene, at least one radical $R^1$ is cyclopentadienyl$^{\ominus}$ which is substituted by at least one group of the formula IV or V

$(R^6)_3Z-$ (IV)

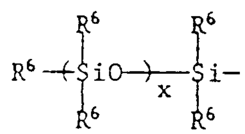

(V)

in which Z is Si or Ge, x is 1, 2 or 3 and each radical $R^6$ independently is linear or branched $C_1$-$C_{18}$alkyl, $C_1$-$C_4$halogenoalkyl, phenyl, $C_1$-$C_{18}$alkoxy or $C_1$-$C_{18}$alkoxymethyl.

**2.** A titanocene according to claim 1, wherein, in formula I, one radical $R^1$ is unsubstituted cyclopentadienyl and the other radical $R^1$ contains up to 3 substituents, or each radical $R^1$ is substituted cyclopentadienyl, at least one substituent corresponding to the formula IV or V.

**3.** A titanocene according to claim 1, in which x is 1 and Z is Si.

**4.** A titanocene according to claim 1, in which $R^6$ is $C_1$-$C_4$alkyl, $C_1$-$C_4$halogenoalkyl, $C_1$-$C_4$alkoxy or phenyl.

**5.** A titanocene according to claim 1, in which, in formula IV, one radical $R^6$ is $C_1$-$C_{18}$alkyl, $C_1$-$C_4$halogenoalkyl, $C_1$-$C_4$alkoxy or phenyl and the other two radicals $R^6$ are methyl.

**6.** A titanocene according to claim 1, in which the group of the formula IV is trimethylsilyl.

**7.** A titanocene according to claim 1, in which one radical $R^1$ is a cyclopentadienyl anion substituted by a group of the formula IV or V and the other radical $R^1$ has the same meaning or is a cyclopentadienyl or methylcyclopentadienyl anion.

**8.** A titanocene according to claim 1, in which $R^2$ and $R^3$ in formula I are identical and are a 6-membered carbocyclic or 5- or 6-membered heterocyclic aromatic ring which is substituted by F in one or both of the ortho-positions relative to the metal-carbon bond or by $CF_3$, $C_2F_5$, $CF_2Cl$ or $CF_2CH_3$ in one ortho-position and can contain other substituents as defined in claim 1.

**9.** A titanocene according to claim 1, in which $R^2$ and $R^3$ are 2,6-difluorophen-1-yl, which can contain 1 to 3 substituents as defined in claim 1.

**10.** A titanocene according to claim 9, in which $R^2$ and $R^3$ are a radical of the formula

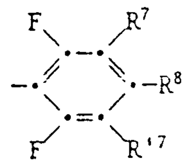

in which $R^7$, $R'^7$ and $R^8$ independently of one another are H, F, Cl or Br, or $R^7$ and $R'^7$ independently of one another are each H, F, Cl or Br, and $R^8$ is a primary, secondary or tertiary amino or aminoalkyl group with up to 20 C atoms or a quaternary ammonium or ammoniumalkyl group with up to 30 C atoms, or $R^8$ is a polyoxaalkylene radical which is free, esterified or etherified and is bonded to the phenyl ring directly or via a bridge group.

**11.** A titanocene according to claim 1, in which $R^2$ contains at least one polyoxaalkylene radical which is free, etherified or esterified and is bonded to the aryl radical directly or via a bridge group.

**12.** A titanocene according to claim 11, in which the polyoxaalkylene radical corresponds to the formula

$$-(C_zH_{2z}O)_{o}DR^9,$$

in which z is a number from 2 to 6, o is a number from 1 to 20 and $R^9$ is H or $C_1$-$C_{18}$alkyl.

**13.** A titanocene according to claim 1, in which $R^2$ is a radical of the formula

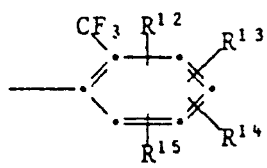

in which $R^{12}$, $R^{13}$, $R^{14}$ and $R^{15}$ independently of one another are hydrogen, $-CF_3$, bromine, chlorine or fluorine and $R^3$ has the meaning of $R^2$ or is halogen or $-N_3$, -CN, -NCO or -NCS.

**14.** A titanocene according to claim 13, in which $R^{12}$, $R^{13}$ and $R^{14}$ are hydrogen and $R^{15}$ is in the ortho-position relative to the metal-carbon bond and is fluorine or hydrogen.

**15.** A titanocene according to claim 13, in which $R^3$ is F, Cl, Br, $N_3$, CN, NCO or NCS.

**16.** A titanocene according to claim 1, which is bis (trimethylsilylcyclopentadienyl)bis(pentafluorophenyl)titanium, bis(trimethylsilylcyclopentadienyl)bis-[4-(1',4',7'-trioxaundecyl)-2,3,5,6-tetrafluorophenyl]titanium, bis(trimethylsilylcyclopentadienyl)-o-trifluoromethylphenyltitanium chloride or bis(trimethylsilylcyclopentadienyl)bis[3-[1,4',7'-trioxahendecyl)-2,6-difluorophenyl]titanium.

**17.** A process for the preparation of a titanocene of the formula I according to claim 1, which comprises reacting 1 mol of a compound of the formula VI

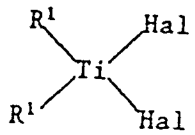

(VI)

in which $R^1$ is as defined in claim 1 and Hal is halogen, in particular chlorine, either with one mol of $LiR^2$ or $LiR^3$ and then with one mol of $LiR^3$ and $LiR^2$ respectively, or with 2 mol of $LiR^2$, $R^2$ and $R^3$ being as defined in claim 1.

**18.** A composition which can be polymerized by radiation and contains (a) at least one non-volatile monomeric, oligomeric or polymeric compound with at least one polymerizable ethylenically unsaturated double bond and (b) at least one titanocene of the formula I according to claim 1 as the photoinitiator.

**19.** A composition according to claim 18, which additionally contains at least one other photoinitiator (c).

**20.** A composition according to claim 19, which contains a benzil ketal, a 4-aroyl-1,3-dioxolane, a dialkoxyacetophenone, an α-hydroxy- or α-aminoacetophenone or a mixture thereof as component (c).

**21.** A coated substrate which is coated with a composition according to claim 18 or 19 on at least one surface.

**22.** A process for the photographic production of relief images, which comprises exposing a coated substrate according to claim 21 imagewise and then removing the non-exposed portions with a solvent.

**23.** The use of a titanocene of the formula I according to claim 1 as a photoinitiator for photopolymerization of a non-volatile monomeric, oligomeric or polymeric compound with at least one polymerizable ethylenically unsaturated double bond.

**24.** A liquid photoinitiator mixture containing a photoinitiator from the class of the benzil ketals, 4-aroyl-1,3-dioxolanes, dialkoxyacetophenones, α-hydroxyacetophenones, α-aminoacetophenones and mixtures thereof and a titanocene of the formula I according to claim 1.

**25.** The use of a composition according to claim 19 for the production of varnishes, printing inks, printing plates or resist materials or as an image-recording material.

**Revendications**

**1.** Titanocènes de formule I

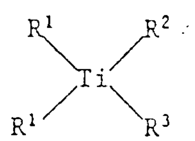

(I),

dans laquelle les deux radicaux $R^1$, indépendamment l'un de l'autre, représentent chacun un radical cyclopentadiényle$^-$ éventuellement substitué par des radicaux alkyle en $C_1$-$C_{18}$,alcényle en $C_2$-$C_{18}$, chloro, phényle ou cyclohexyle, ou encore les radicaux $R^1$ forment ensemble un radical substitué de formule II

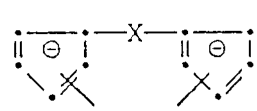

(II)

dans laquelle X est $(CH_2)_n$, avec n = 1, 2 ou 3, un radical alkylidène ayant de 2 à 12 atomes de carbone et éventuellement substitué par des radicaux phényle, ou cycloalkylidène ayant de 5 à 7 atomes de carbone nucléaires,

$R^2$ est un noyau aromatique carbocyclique à 6 chaînons ou hétérocyclique à 5 ou 6 chaînons, qui, au moins sur l'une des deux positions ortho par rapport à la liaison métal-carbone, est substitué par F, $CF_3$, $C_2F_5$, $CF_2Cl$ ou $CF_2CH_3$, et qui de plus peut être substitué par un ou plusieurs des groupements halogéno, alkyle en $C_1$-$C_{12}$, alcoxy en $C_1$-$C_4$, (alcoxy en $C_2$-$C_{10}$)carbonyle, aminocarbonyle ayant jusqu'à 12 atomes de carbone ou encore par un groupe amino- ou aminoalkyle primaire, secondaire ou tertiaire ayant jusqu'à 20 atomes de carbone, ou par un groupe ammonium ou ammonium-alkyle quaternaire ayant jusqu'à 30 atomes de carbone, ou bien encore, quand $R^2$ est un noyau aromatique substitué par des atomes de fluor, ce dernier peut être substitué par au moins un résidu polyoxaalkylène èventuellement éthérifié ou estérifié, ce résidu pouvant être lié au noyau aromatique, directement ou par l'intermédiaire d'un groupement pontant, ou bien encore $R^2$ et $R^3$ forment ensemble un résidu de formule III

-Q-Y-Q- (III)

dans laquelle Q représente un noyau aromatique carbocyclique, lequel est lié à l'atome de titane en position 2 par rapport au groupe Y et est substitué par le fluor en position 3, Y est le radical méthylène, un radical alkylidène en $C_2$-$C_{12}$ éventuellement substitué par des radicaux phényle, cycloalkylidène en $C_5$-$C_7$, un groupe $-NR^5-$, -O-, -S-, -SO-, $-SO_2-$, -CO-, $-SiR^4{}_2-$ ou $-SnR^4{}_2-$, et $R^5$ est un hydrogène ou un radical alkyle en $C_1$-$C_{12}$, cyclohexyle, phényle, tolyle ou benzyle, et les radicaux $R^4$, indépendamment l'un de l'autre, représentent chacun un radical alkyle en $C_1$-$C_{12}$,cyclohexyle, phényle ou benzyle,

$R^3$ a l'une des significations données pour $R^2$ ou représente un radical alcynyle en $C_2$-$C_{12}$ ou phénylalcynyle ayant de 2 à 5 atomes de carbone dans le fragment alcyne, et éventuellement substitué dans le radical phényle par des groupements halogéno ou alkyle en $C_1$-$C_4$, ou encore un groupe $-SiR^4{}_3$, $-SnR^4{}_3$ où les radicaux $R^4$ ont les significations données ci-dessus, $-N_3$ ou -CN, ou encore $R^3$ représente de plus un halogène, -NCO ou -NCS quand $R^2$ est un noyau aromatique substitué par $-CF_3$, $-C_2F_5$, $CF_2Cl$ ou $CF_3CH_3$.

**2.** Titanocènes selon la revendication 1, caractérisés en ce que, dans la formule I, l'un des radicaux $R^1$ est un cyclopentadiényle non substitué et l'autre radical $R^1$ contient jusqu'à 3 substituants, ou bien chaque radical $R^1$ est un cyclopentadiényle non substitué, au moins un substituant ayant la formule IV ou V.

**3.** Titanocènes selon la revendication 1, caractérisés en ce que x vaut 1 et Z est Si.

**4.** Titanocènes selon la revendication 1, caractérisés en ce que $R^6$ est un radical alkyle en $C_1$-$C_4$, halogènalkyle en $C_1$-$C_4$, alcoxy en $C_1$-$C_4$ ou phényle.

**5.** Titanocènes selon la revendication 1, caractérisés en ce que, dans la formule IV, $R^6$ est un radical alkyle en $C_1$-$C_{18}$, halogènalkyle en $C_1$-$C_4$, alcoxy en $C_1$-$C_4$ ou phényle, et les deux autres radicaux $R^6$ sont des radicaux méthyle.

**6.** Titanocènes selon la revendication 1, caractérisés en ce que le groupe de formule IV est le groupement triméthylsilyle.

**7.** Titanocènes selon la revendication 1, caractérisés en ce que l'un des radicaux $R^1$ est un anion cyclopentadiényle substitué par les groupes de formules IV ou V, et l'autre radical $R^1$ a la même signification ou est un anion cyclopentadiényle ou méthylcyclopentadiényle.

**8.** Titanocènes selon la revendication 1, caractérisés en ce que $R^2$ et $R^3$, dans la formule I, sont identiques et forment un noyau aromatique carbocyclique à 6 chaînons ou hétérocyclique à 5 ou 6 chaînons, qui sur l'une des deux positions ortho, ou sur les deux positions ortho par rapport à la liaison métal-carbone, est substitué par F ou encore dans une position ortho par $CF_3$, $C_2F_5$, $CF_2Cl$ ou $CF_2CH_3$, et peut contenir d'autres substituants tels que définis dans la revendication 1.

**9.** Titanocènes selon la revendication 1, caractérisés en ce que $R^2$ et $R^3$ sont chacun le radical difluoro-2,6 phényle-1, qui peut contenir de 1 à 3 substituants tels que définis dans la revendication 1.

**10.** Titanocènes selon la revendication 9, caractérisés en ce que $R^2$ et $R^3$ représentent un radical de formule

$(R^6)_3Z-$ (IV)

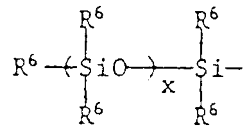 (V)

dans laquelle $R^7$, $R'^7$ et $R^8$, indépendamment les uns des autres, représentent chacun H, F, Cl ou Br, ou encore $R^7$ et $R'^7$, indépendamment l'un de l'autre, représentent chacun H, F, Cl ou Br, et $R^8$ est un groupe amino ou aminoalkyle primaire, secondaire ou tertiaire ayant jusqu'à 20 atomes de carbone ou un groupe ammonium ou ammoniumalkyle quaternaire ayant jusqu'à 30 atomes de carbone, ou bien $R^8$ est un radical polyoxaalkylène éventuellement estérifié ou éthérifié, lequel est lié au noyau phényle directement ou par l'intermédiaire d'un groupe pontant.

**11.** Titanocènes selon la revendication 1, caractérisés en ce que $R^2$ contient au moins un radical polyoxaalkylène éventuellement éthérifié ou estérifié, lié au radical aryle directement ou par l'intermédiaire d'un groupe pontant.

**12.** Titanocènes selon la revendication 11, caractérisés en ce que le radical polyoxaalkylène correspond à la formule

$-(C_zH_{2z}O)o-R^9$,

dans laquelle z est un nombre de 2-6, o est un nombre de 1 à 20 et $R^9$ est H ou un radical alkyle en $C_1$-$C_{18}$.

**13.** Titanocènes selon la revendication 1, caractérisés en ce que $R^2$ est un radical de formule

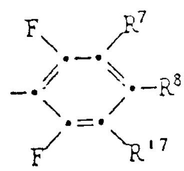

dans laquelle $R^{12}$, $R^{13}$, $R^{14}$ et $R^{15}$, indépendamment les uns des autres, représentent chacun un hydrogène, $-CF_3$, bromo, chloro, chloro ou fluoro, et $R^3$ a les significations de $R^2$ ou représente un halogène ou $-N_3$, -CN, -NCO ou -NCS.

**14.** Titanocènes selon la revendication 13, caractérisés en ce que $R^{12}$, $R^{13}$ et $R^{14}$ sont chacun un hydrogène, $R^{15}$ est en position ortho par rapport à la liaison métallique et représente un fluor ou un hydrogène.

**15.** Titanocènes selon la revendication 13, caractérisés en ce que $R^3$ représente F, Cl, Br, $N_3$, CN, NCO ou NCS.

**16.** Titanocènes selon la revendication 1, caractérisés en ce qu'il s'agit des composés suivants : Bis(triméthylsilylcyclopentadiényl) bis(pentafluorophényl) titane, bis(triméthylsilylcyclopentadiényl) bis[-(trioxa-1,4,7 undécyl)-4 tétrafluorophényl-2,3,5,6] titane, chlorure de bis(triméthylsilylcyclopentadiényl) o-trifluorométhylphényl titane ou bis(triméthylsilylcyclopentadiényl) bis[(trioxa-1,4,7 hendécyl-2)-3 difluoro-6 phényl)] titane.

**17.** Procédé pour préparer des titanocènes de formule I selon la revendication 1, caractérisés en ce que l'on fait réagir 1 mole d'un composé de formule VI

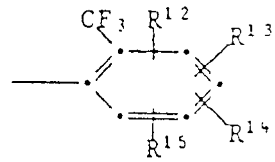

dans laquelle $R^1$ a la signification donnée dans la revendication 1 et Hal représente un halogène, en particulier le chlore, soit avec une 1 mole de $LiR^2$ ou de $LiR^3$, puis avec 1 mole de $LiR^3$ ou $LiR^2$, ou encore avec 2 moles de $LiR^2$, $R^2$ et $R^3$ ayant la signification donnée dans la revendication 1.

**18.** Composition polymérisable sous l'effet d'un rayonnement, contenant (a) au moins un composé monomère, oligomère ou polymère non volatil comportant au moins une double liaison polymérisable à insaturation éthylénique, et (b) au moins un titanocène de formule I selon la revendication 1 en tant que photoamorceur.

**19.** Composition selon la revendication 18, caractérisée en ce qu'elle contient en outre au moins un autre photoamorceur (c).

**20.** Composition selon la revendication 19, contenant comme composant (c) un benzylcétal, un aroyl-4 dioxolanne-1,3, une dialcoxyacétophénone, une $\alpha$-hydroxy- ou une $\alpha$-aminoacétophénone ou leurs mélanges.

**21.** Substrat enduit, enduit sur au moins une surface d'une composition selon la revendication 18 ou 19.

**22.** Procédé pour préparer par voie photographique des images en relief, caractérisé en ce qu'on expose selon l'image un substrat enduit selon la revendication 21, puis qu'on élimine avec un solvant les zones non exposées.

**23.** Utilisation de titanocènes de formule I selon la revendication 1, en tant que photoamorceurs pour la photopolymérisation de composés monomères, oligomères ou polymères non volatils comportant au moins une double liaison polymérisable à insaturation éthylénique.

**24.** Mélange de photoamorceurs liquides, contenant un photoamorceur de la classe comprenant les benzylcétals, les aroyl-4 dioxolannes-1,3, les dialcoxyacétophénones, les $\alpha$-hydroxyacétophénones, les $\alpha$-aminoacétophénones ou leurs mélanges, et un titanocène de formule I selon la revendication 1.

**25.** Utilisation d'une composition selon la revendication 19 pour préparer des vernis, des encres d'imprimerie, des clichés d'impression, des matériaux de réserve, et servant aussi de matériau d'enregistrement d'images.